(19) Europäisches Patentamt
European Patent Office
Office européen des brevets

(11) **EP 2 984 151 B1**

(12) **EUROPÄISCHE PATENTSCHRIFT**

(45) Veröffentlichungstag und Bekanntmachung des Hinweises auf die Patenterteilung:
**25.04.2018 Patentblatt 2018/17**

(21) Anmeldenummer: **14711161.1**

(22) Anmeldetag: **18.03.2014**

(51) Int Cl.:
***C09K 11/06*** (2006.01) ***H01L 51/00*** (2006.01)
***H01L 51/50*** (2006.01) ***H01L 51/56*** (2006.01)
***H01L 27/32*** (2006.01) ***H01L 33/00*** (2010.01)

(86) Internationale Anmeldenummer:
**PCT/EP2014/000741**

(87) Internationale Veröffentlichungsnummer:
**WO 2014/166585 (16.10.2014 Gazette 2014/42)**

# (54) ORGANISCHE ELEKTROLUMINESZENZVORRICHTUNG

ORGANIC ELECTROLUMINESCENT DEVICE

DISPOSITIF ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.04.2013 EP 13001800**

(43) Veröffentlichungstag der Anmeldung:
**17.02.2016 Patentblatt 2016/07**

(73) Patentinhaber: **Merck Patent GmbH**
**64293 Darmstadt (DE)**

(72) Erfinder:
- **STOESSEL, Philipp**
  **60487 Frankfurt am Main (DE)**
- **PARHAM, Amir, Hossain**
  **60486 Frankfurt am Main (DE)**
- **PFLUMM, Christof**
  **64291 Darmstadt (DE)**
- **JATSCH, Anja**
  **60489 Frankfurt am Main (DE)**
- **KAISER, Joachim**
  **64289 Darmstadt (DE)**

(56) Entgegenhaltungen:
**EP-A1- 1 956 022** **EP-A1- 2 080 762**
**WO-A1-2011/073149** **DE-A1-102009 009 277**
**DE-A1-102009 023 155** **DE-A1-102009 031 021**

- **HIROKI UOYAMA ET AL: "Highly efficient organic light-emitting diodes from delayed fluorescence", NATURE, Bd. 492, Nr. 7428, 12. Dezember 2012 (2012-12-12), Seiten 234-238, XP055048388, ISSN: 0028-0836, DOI: 10.1038/nature11687 in der Anmeldung erwähnt**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 2 984 151 B1

## Beschreibung

Die vorliegende Erfindung betrifft organische Elektrolumineszenzvorrichtungen, welche Mischungen aus einem lumineszenten Material mit einem geringen Singulett-Triplett-Abstand und bestimmten Matrixmaterialien enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei insbesondere auch metallorganische Iridium- und Platinkomplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich.

Trotz der guten Ergebisse, die mit metallorganischen Iridum- und Platinkomplexen erzielt werden, weisen diese jedoch auch eine Reihe von Nachteilen auf: So handelt es sich bei Iridium und Platin um seltene und teure Metalle. Es wäre daher zur Ressourcenschonung wünschenswert, die Verwendung dieser seltenen Metalle vermeiden zu können. Weiterhin weisen derartige Metallkomplexe teilweise eine geringere thermische Stabilität auf als rein organische Verbindungen, insbesondere bei der Sublimation so dass auch aus diesem Grund die Verwendung rein organischer Verbindungen vorteilhaft wäre, sofern diese zu vergleichbar guten Effizienzen führen. Weiterhin sind blau, insbesondere tiefblau phosphoreszierende Iridium- bzw. Platinemitter mit hoher Effizienz und Lebensdauer technisch nur schwierig zu verwirklichen, so dass es auch hier Verbesserungsbedarf gibt. Weiterhin gibt es insbesondere bei der Lebensdauer phosphoreszierender OLEDs, welche Ir- oder Pt-Emitter enthalten, Verbesserungsbedarf, wenn die OLED bei höherer Temperatur betrieben wird, wie dies für einige Anwendungen erforderlich ist.

Eine alternative Entwicklung ist die Verwendung von Emittern, die thermisch aktivierte verzögerte Fluoreszenz (thermally activated delayed fluorescence, TADF) zeigen (z. B. H. Uoyama et al., Nature 2012, Vol. 492, 234). Hier handelt es sich um organische Materialien, bei denen der energetische Abstand zwischen dem niedrigsten Triplettzustand $T_1$ und dem ersten angeregten Singulettzustand $S_1$ so klein ist, dass dieser Energieabstand kleiner oder im Bereich der thermischen Energie liegt. Aus quantenstatistischen Gründen entstehen bei elektronischer Anregung in der OLED die angeregten Zustände zu 75 % im Triplettzustand und zu 25 % im Singulettzustand. Da rein organische Moleküle üblicherweise nicht aus dem Triplettzustand emittieren können, können 75 % der angeregten Zustände nicht für die Emission genutzt werden, wodurch prinzipiell nur 25 % der Anregungsenergie in Licht umgewandelt werden können. Ist nun jedoch der energetische Abstand zwischen dem niedrigsten Triplettzustand und dem niedrigsten angeregten Singulettzustand nicht oder nicht wesentlich größer als die thermische Energie, die durch kT beschrieben wird, so ist aus dem Triplettzustand durch thermische Anregung der erste angeregte Singulettzustand des Moleküls zugänglich und kann thermisch besetzt werden. Da dieser Singulettzustand ein emissiver Zustand ist, aus dem Fluoreszenz möglich ist, kann dieser Zustand zur Erzeugung von Licht verwendet werden. Somit ist prinzipiell die Umwandlung von bis zu 100 % der elektrischen Energie in Licht möglich bei der Verwendung rein organischer Materialien als Emitter. So wird im Stand der Technik eine externe Quanteneffizienz von mehr als 19 % beschrieben, was in derselben Größenordnung wie für phosphoreszierende OLEDs liegt. Somit ist es mit derartigen rein organischen Materialien möglich, sehr gute Effizienzen zu erreichen und gleichzeitig die Verwendung seltener Metalle wie Iridium oder Platin zu vermeiden. Weiterhin ist es mit solchen Materialien auch möglich, hocheffiziente blau emittierende OLEDs zu erzielen.

Im Stand der Technik wird die Verwendung verschiedener Matrixmaterialien in Verbindung mit Emittern, die thermisch aktivierte verzögerte Fluoreszenz zeigen (im Folgenden TADF-Verbindung genannt), beschrieben, beispielsweise Carbazolderivate (H. Uoyama et al., Nature 2012, 492, 234; Endo et al., Appl. Phys. Lett. 2011, 98, 083302; Nakagawa et al., Chem. Commun. 2012, 48, 9580; Lee et al., Appl. Phys. Lett. 2012, 101, 093306/1), Phosphinoxid-Dibenzothiophenderivate (H. Uoyama et al., Nature 2012, 492, 234) oder Silanderivate (Mehes et al., Angew. Chem. Int. Ed. 2012, 51, 11311; Lee et al., Appl. Phys. Lett. 2012, 101, 093306/1). Indenocarbazol- bzw. Indolocarbazolderivate sind in diesen Vorrichtungen als Matrixmaterialien nicht beschrieben.

Indolocarbazol Matrixmaterialen gemäß Formel 1 sind bekannt, z.B. Verbindung 9, Abschnitte [0048]-[0059]) aus der Veröffentlichung EP 1 956 022 A1 (NIPPON STEEL CHEMICAL CO [JP]) 13. August 2008 (2008-08-13). Generell gibt es bei organischen Elektrolumineszenzvorrichtungen, die Emission nach dem TADF-Mechanismus zeigen, noch weiteren Verbesserungsbedarf, insbesondere im Hinblick auf Effizienz, Spannung, Lebensdauer und Rott-Off-Verhatten. Die der vorliegenden Erfindung zugrunde liegende technische Aufgabe ist somit die Bereitstellung von OLEDs, deren Emission auf TADF basiert und die verbesserte Eigenschaften aufweisen, insbesondere in Bezug auf eine oder mehrere der oben genannten Eigenschaften.

Überraschend wurde gefunden, dass organische Elektrolumineszenzvorrichtungen, die in der emittierenden Schicht ein organisches TADF-Molekül und ein Indenocarbazolderivat, Indolocarbazolderivat oder eines der weiteren im Folgenden aufgeführten Derivate aufweisen, diese Aufgabe lösen und zu Verbesserungen der organischen Elektrolumineszenzvorrichtung führen. Derartige organische Elektrolumineszenzvorrichtungen sind daher der Gegenstand der vorliegenden Erfindung.

Gegenstand der vorliegenden Erfindung ist eine organische Elektrolumineszenzvorrichtung, enthaltend Kathode, Anode und emittierende Schicht, die die folgenden Verbindungen enthält:

(A) eine lumineszente organische Verbindung gemäß Anspruch 1, die einen Abstand zwischen dem niedrigsten Triplettzustand $T_1$ und dem ersten angeregten Singulettzustand $S_1$ von ≤ 0.15 eV aufweist; und

(B) eine Verbindung gemäß der folgenden Formel (1),

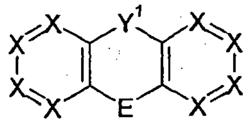

Formel (1)

wobei für die verwendeten Symbole gilt:

X ist bei jedem Auftreten gleich oder verschieden CR oder N oder eine Gruppe X-X steht für eine Gruppe der folgenden Formel (2), mit der Maßgabe, dass in der Verbindung der Formel (1) mindestens eine Gruppe X-X für eine Gruppe der Formel (2) steht und dass pro Cyclus maximal eine Gruppe X-X für eine Gruppe der Formel (2) steht,

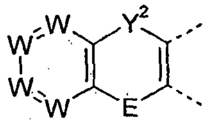

Formel (2)

wobei die C-Atome mit den gestrichelten Bindungen die Bindung der Gruppe andeuten;

$Y^1$, $Y^2$ ist bei jedem Auftreten gleich oder verschieden ausgewählt aus der Gruppe bestehend aus $CR_2$, NR, O, S, $SiR_2$, BR, PR und P(=O)R;

E ist bei jedem Auftreten gleich oder verschieden ausgewählt aus der Gruppe bestehend aus einer Einfachbindung, $CR_2$, NR, O, S, $SiR_2$, BR, PR und P(=O)R;

W ist bei jedem Auftreten gleich oder verschieden CR oder N;

R ist bei jedem Auftreten gleich oder verschieden ausgewählt aus der Gruppe bestehend aus H, D, F, Cl, Br, I, CN, $NO_2$, $N(Ar)_2$, $N(R^1)_2$, C(=O)Ar, $C(=O)R^1$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, C≡C, $Si(R^1)_2$, C=O, C=S, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Aralkyl- oder Heteroaralkylgruppe mit 5 bis 60 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar)_2$, $N(R^2)_2$, C(=O)Ar, $C(=O)R^2$, $P(=O)(Ar)_2$, einer geradkettigen Alkyl-, Alkoxy- oder Thioalkylgruppe mit 1 bis 40 C-Atomen oder einer verzweigten oder cyclischen Alkyl, Alkoxy- oder Thioalkylgruppe mit 3 bis 40 C-Atomen oder einer Alkenyl- oder Alkinylgruppe mit 2 bis 40 C-Atomen, die jeweils mit einem oder

mehreren Resten $R^2$ substituiert sein kann, wobei eine oder mehrere nicht-benachbarte $CH_2$-Gruppen durch $R^2C=CR^2$, C≡C, $Si(R^2)_2$, C=O, C=S, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder eine Aralkyl- oder Heteroaralkylgruppe mit 5 bis 60 aromatischen Ringatomen, wobei optional zwei oder mehr benachbarte Substituenten $R^1$ ein monocyclisches oder polycyclisches, aliphatisches, aromatisches oder heteroaromatisches Ringsystem bilden können, das mit einem oder mehreren Resten $R^2$ substituiert sein kann;

Ar ist bei jedem Auftreten gleich oder verschieden ein aromatisches oder heteroaromatisches Ringsystem mit 5-30 aromatischen Ringatomen, das mit einem oder mehreren nicht-aromatischen Resten $R^2$ substituiert sein kann; dabei können zwei Reste Ar, welche an dasselbe N-Atom oder P-Atom binden, auch durch eine Einfachbindung oder eine Brücke, ausgewählt aus $N(R^2)$, $C(R^2)_2$, O oder S, miteinander verbrückt sein;

$R^2$ ist ausgewählt aus der Gruppe bestehend aus H, D, F, CN, einem aliphatischem Kohlenwasserstoffrest mit 1 bis 20-C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können.

Der oben genannte und auch im Folgenden verwendete Begriff "po Cyclus" bezieht sich im Sinne der vorliegenden Anmeldung auf jeden einzelnen in der Verbindung der Formel (1) enthaltenen Ring, also auf jeden einzelnen 5- bzw. 6-Ring.

Benachbarte Substituenten im Sinne der vorliegenden Anmeldung sind Substituenten, die enfinreder an dasselbe Kohlenstöffatom gebunden sind oder die an Kohlenstoffatome gebunden sind, die wiederum direkt aneinander gebunden sind.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 80 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein C-, N- oder O-Atom, verbunden sein können. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine kurze Allylgruppe verbunden sind.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 40 C-Atome enthalten kann, und in der auch einzelne H-Atome oder $CH_2$-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio,

Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio; Hexinylthio, Heptinylthio oder Octinylthio verstanden. Allgemein können Alkyl-, Alkoxy- oder Thioalkylgruppen gemäß der vorliegenden Erfindung geradkettig, verzweigt oder cyclisch sein, wobei eine oder mehrere nicht-benachbarte $CH_2$-Gruppen durch die oben genannten Gruppen ersetzt sein können; weiterhin können auch ein oder mehrere H-Atome durch D, F, Cl, Br, I, CN oder $NO_2$, bevorzugt F, Cl oder CN, weiter bevorzugt F oder CN, besonders bevorzugt CN ersetzt sein.

Unter einem aromatischen oder heteroaromatischen Ringsystem mit 5 - 30 bzw. 5 - 60 aromatischen Ringatomen, welches noch jeweils mit den oben genannten Resten R, $R^1$ oder $R^2$ substituiert sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol,:1,2,3-Thiadiazol, 1,2,4-Thiadiazol, 1,2-,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombinationen dieser Systeme.

Im Folgenden wird die lumineszente organische Verbindung, die einen Abstand zwischen dem niedrigsten Triplettzustand $T_1$ und dem ersten angeregten Singulettzustand $S_1$ von $\leq 0.15$ eV aufweist, näher beschrieben. Hierbei handelt es sich um eine Verbindung, die TADF (thermally activated delayed fluorescence) zeigt. Diese Verbindung wird in der folgenden Beschreibung mit "T7ADF-Verbindung" abgekürzt.

Eine organische Verbindung im Sinne der vorliegenden Erfindung ist eine kohlenstoffhaltige Verbindung, die keine Metalle enthält. Insbesondere ist die organische Verbindung aus den Eiementen C, H, D, B, Si, N, P, O, S, F, Cl, Br und I aufgebaut.

Eine lumineszente Verbindung im Sinne der vorliegenden Erfindung ist eine Verbindung, die in der Lage ist, unter optischer Anregung in einer Umgebung, wie sie in der organischen Elektrolumineszenzvorrichtung vorliegt, bei Raumtemperatur Licht zu emittieren. Dabei weist die Verbindung bevorzugt eine Lumineszenzquanteneffizienz von mindestens 40 % auf, besonders bevorzugt von mindestens 50 %, ganz besonders bevorzugt von mindestens 60 % und insbesondere bevorzugt von mindestens 70 %. Dabei wird die Lumineszenzquanteneffizienz bestimmt in einer Schicht in Mischung mit dem Matrixmaterial, wie sie in der organischen Elektrolumineszenzvorrichtung verwendet werden soll. Wie die Bestimmung der Lumineszenzquantenausbeute im Sinne der vorliegenden Erfindung durchgeführt wird, ist im Beispielteil ausführlich allgemein beschrieben.

Weiterhin ist es bevorzugt, wenn die TADF-Verbindung eine kurze Abklingzeit aufweist. Dabei ist die Abklingzeit bevorzugt $\leq 50$ µs. Wie die Bestimmung der Abklingzeit im Sinne der vorliegenden Erfindung durchgeführt wird, ist im Beispielteil ausführlich allgemein beschrieben.

Die Energie des niedrigsten angeregten Singulettzustands ($S_1$) und des niedrigsten Triplettzustands ($T_1$) werden durch quantenchemische Rechnung bestimmt. Wie diese Bestimmung im Sinne der vorliegenden Erfindung durchgeführt wird, ist im Beispielteil ausführlich allgemein beschrieben.

Wie oben beschrieben, darf der Abstand zwischen $S_1$ und $T_1$ maximal 0.95 eV betragen, damit es sich bei der Verbindung um eine TADF-Verbindung im Sinne der vorliegenden Erfindung handelt. Bevorzugt ist der Abstand zwischen $S_1$ und $T_1 \leq 0.10$ eV, besonders bevorzugt $\leq 0.08$ eV, ganz besonders bevorzugt $\leq 0.05$ eV.

Bei der TADF-Verbindung handelt es sich bevorzugt um eine aromatische Verbindung, die sowohl Donor- wie auch Akzeptorsubstituenten aufweist, wobei das LUMO und das HOMO der Verbindung räumlich nur schwach überlappen. Was unter Donor- bzw. Akzeptorsubstituenten verstanden wird, ist dem Fachmann prinzipiell bekannt. Geeignete Donorsubstituenten sind insbesondere Diaryl- bzw. -heteroarylaminogruppen sowie Carbazolgruppen bzw. Carbazolderivate, die jeweils bevorzugt über N an die aromatische Verbindung gebunden sind. Dabei können diese Gruppen auch weiter substituiert sein. Geeignete Akzeptorsubstituenten sind insbesondere Cyanogruppen, aber auch beispielsweise elektronenarme Heteroarylgruppen, die auch weiter substituiert sein können.

Um Exziplexbildung in der emittierenden Schicht zu vermeiden, ist es bevorzugt, wenn für LUMO(TADF), also das LUMO der TADF-Verbindung, und das HOMO(Matrix), also das HOMO der Verbindung gemäß Formel (1), gilt:

$$\mathrm{LUMO(TADF)} - \mathrm{HOMO(Matrix)} > S_1\mathrm{(TADF)} - 0.4\ \mathrm{eV};$$

besonders bevorzugt:

$$\mathrm{LUMO(TADF)} - \mathrm{HOMO(Matrix)} > S_1\mathrm{(TADF)} - 0.3\ \mathrm{eV};$$

und ganz besonders bevorzugt:

$$\mathrm{LUMO(TADF)} - \mathrm{HOMO(Matrix)} > S_1\mathrm{(TADF)} - 0.2\ \mathrm{eV}.$$

Dabei ist $S_1$(TADF) der erste angeregte Singulettzustand $S_1$ der TADF-Verbindung.

Beispiele für geeignete TADF-Verbindungen sind die in der folgenden Tabelle aufgeführten Strukturen.

| | | |
|---|---|---|
| 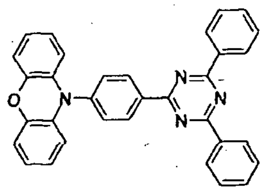 | 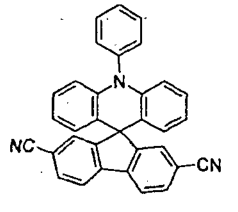 | 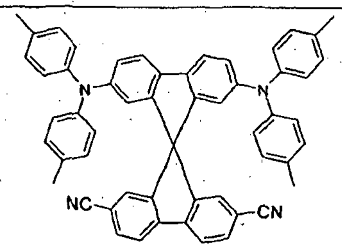 |
| 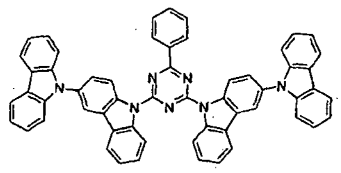 | 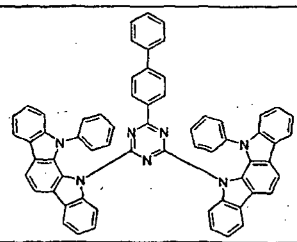 | 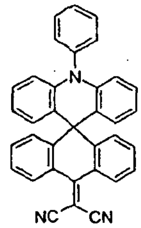 |
| 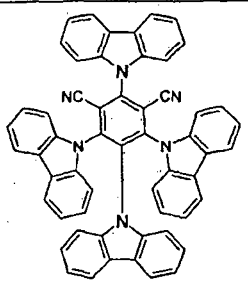 | 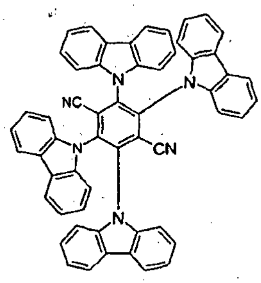 | 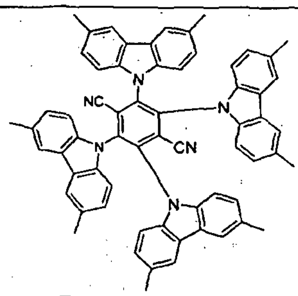 |
| 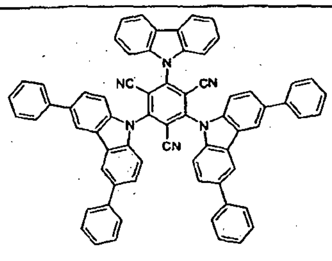 | 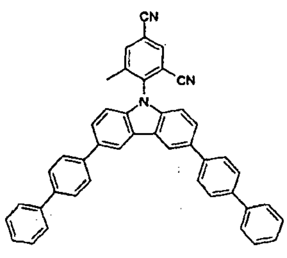 | 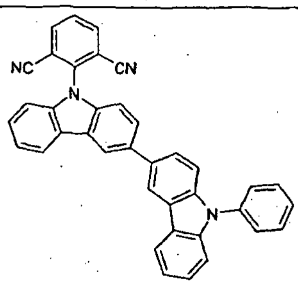 |

| | | |
|---|---|---|
| 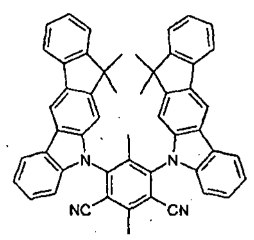 | 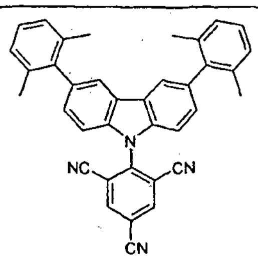 | 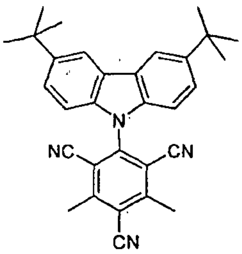 |
| 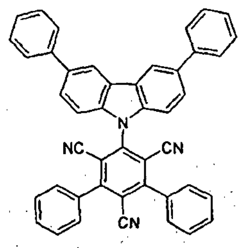 | 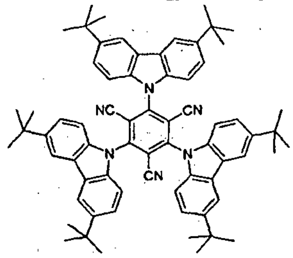 | 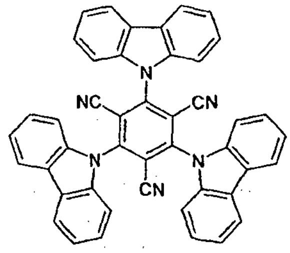 |

In einer bevorzugten Ausführungsform der Erfindung ist die Verbindung gemäß Formel (1) das Matrixmaterial für die TADF-Verbindung. Dabei ist die TADF-Verbindung in der Mischung die emittierende Verbindung, d. h. die Verbindung, deren Emission aus der emittierenden Schicht beobachtet wird, während die Verbindung der Formel (1), die als Matrixmaterial dient, nicht oder nicht wesentlich zur Emission der Mischung beiträgt.

In einer bevorzugten Ausführungsform der Erfindung besteht die emittierende Schicht nur aus der Verbindung der Formel (1) und der TADF-Verbindung.

Damit die Verbindung, die TADF zeigt, die emittierende Verbindung in der Mischung der emittierenden Schicht ist, ist es bevorzugt, dass die niedrigste Triplettenergie der Verbindung der Formel (1) maximal 0.1 eV niedriger ist als die Triplettenergie der TADF-Verbindung. Insbesondere bevozugt ist $T_1$(Matrix) $\geq$ $T_1$(TADF). Besonders bevorzugt gilt: $T_1$(Matrix) - $T_1$(TADF) $\geq$ 0.1 eV, ganz besonders bevorzugt $T_1$(Matrix) - $T_1$(TADF) $\geq$ 0.2 eV. Dabei steht $T_1$(Matrix) für die niedrigste Triplettenergie der Verbindung der Formel (1) und $T_1$(TADF) für die niedrigste Triplettenergie der TADF-Verbindung. Dabei wird die Triplettenergie der Matrix durch quantenchemische Rechnung bestimmt, wie hinten im Beispielteil allgemein beschrieben.

Im Folgenden werden bevorzugte Ausführungsformen der Verbindungen gemäß Formel (1) beschrieben.

Wie oben beschrieben, steht in der Verbindung der Formel (1) mindestens eine Gruppe X-X für eine Gruppe der Formel (2) und pro Cyclus steht maximal eine Gruppe X-X für eine Gruppe der Formel (2). Die Gruppe X-X ist hier mit einer Einfachbindung angedeutet. Da die Gruppe X-X in der Verbindung der Formel (1) jedoch in einer aromatischen Gruppe gebunden ist, ist offensichtlich, dass hiermit eine aromatische Bindung gemeint ist, d. h. der Bindungsgrad der Bindung zwischen den beiden Atomen X liegt zwischen 1 und 2. Dabei ist die Gruppe der Formel (2) in beliebigen Positionen gebunden, und die Gruppen $Y^1$ und $Y^2$ können entweder in cis- oder in trans-Konfiguration zueinander stehen. Die Gruppen X, die nicht für eine Gruppe der Formel (2) stehen, stehen gleich oder verschieden bei jedem Auftreten für CR oder N.

In einer bevorzugten Ausführungsform der Erfindung ist E bei jedem Auftreten gleich oder verschieden ausgewählt aus der Gruppe bestehend aus einer Einfachbindung, $CR_2$, NR, O oder S. Besonders bevorzugt steht E für eine Einfachbindung.

Bevorzugte Verbindungen der Formel (1) sind die Verbindungen der folgenden Formeln (3) bis (9),

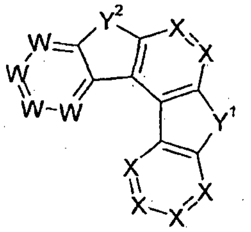

Formel (3)

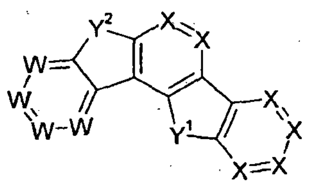

Formel (4)

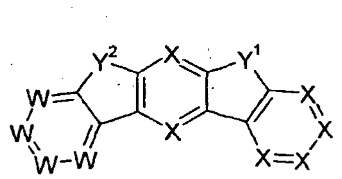

Formel (5)

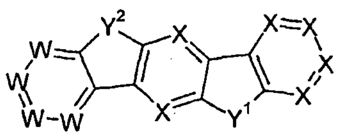

Formel (6)

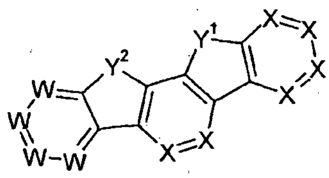

Formel (7)

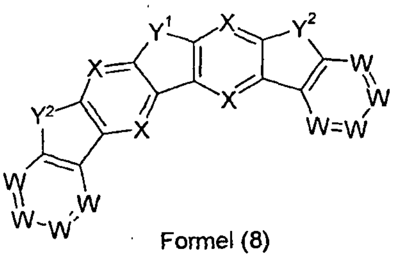

Formel (8)

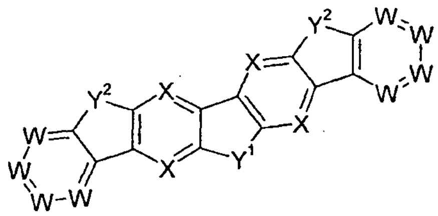

Formel (9)

wobei W, $Y^1$, $Y^2$, R, $R^1$ und $R^2$ die oben genannten Bedeutungen aufweisen und weiterhin gilt:

X ist bei jedem Auftreten gleich oder verschieden CR oder N.

In bevorzugten Gruppen der oben genannten Formeln (1) und (3) bis (9) stehen maximal zwei Symbole X pro Cyclus für N, besonders bevorzugt steht maximal ein Symbol X pro Cyclus für N. Ganz besonders bevorzugt steht das Symbol X gleich oder verschieden bei jedem Auftreten für CR.

In bevorzugten Gruppen der oben genannten Formeln (2) bis (9) stehen maximal zwei Symbole W pro Cyclus für N, besonders bevorzugt steht maximal ein Symbol W pro Cyclus für N. Ganz besonders bevorzugt steht das Symbol W gleich oder verschieden bei jedem Auftreten für CR.

Insbesondere bevorzugt stehen in den Formeln (3) bis (9) alle Symbole X und alle Symbole W gleich oder verschieden für CR.

Bevorzugte Ausführungsformen der Formeln (3) bis (9) sind die Verbindungen der folgenden Formeln (3a) bis (9a),

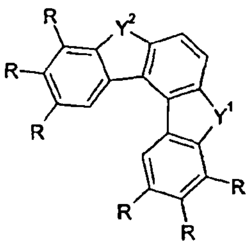

Formel (3a)

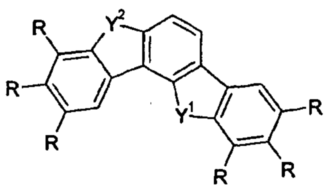

Formel (4a)

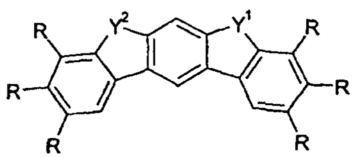

Formel (5a)

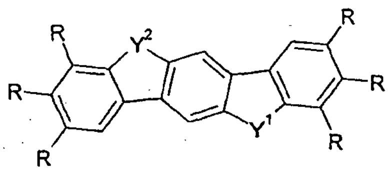

Formel (6a)

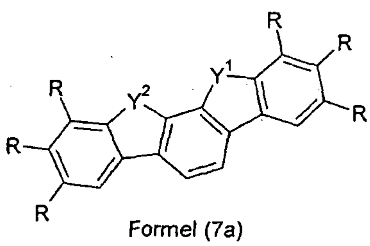

Formel (7a)

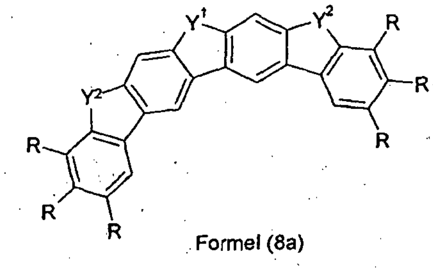

Formel (8a)

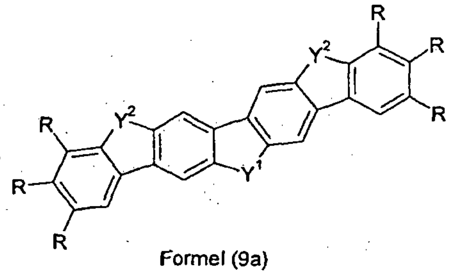

Formel (9a)

wobei die verwendeten Symbole die oben genannten Bedeutungen aufweisen.

In einer weiteren bevorzugten Ausführungsform der Erfindung sind $Y^1$ und $Y^2$ gleich oder verschieden bei jedem Auftreten ausgewählt aus der Gruppe bestehend aus $CR_2$, NR, O oder S.

In den Gruppen der Formel (1) bzw. (3) bis (9) bzw. (3a) bis (9a) kommen für die Gruppen $Y^1$ und $Y^2$ alle Kombinationen in Frage. Bevorzugt steht mindestens eine Gruppe $Y^1$ und/oder $Y^2$ für ein Heteroatom, d. h. bevorzugt ist mindestens eine der Gruppen $Y^1$ und/oder $Y^2$ von $CR_2$ verschieden.

Bevorzugte Kombinationen aus $Y^1$ und $Y^2$ sind die in der folgenden Tabelle aufgeführten Kombinationen.

| $Y^1$ | $Y^2$ |
|---|---|
| $CR_2$ | $CR_2$ |
| $CR_2$ | NR |
| $CR_2$ | O |
| $CR_2$ | S |
| NR | $CR_2$ |
| NR | NR |
| NR | O |
| NR | S |
| O | $CR_2$ |
| O | NR |
| O | O |
| O | S |
| S | $CR_2$ |
| S | NR |
| S | O |
| S | S |

Bevorzugt sind Verbindungen der Formel (1) bzw. (3) bis (9) bzw. (3a) bis (9a), in denen eine der Gruppen $Y^1$ bzw. $Y^2$ für $CR_2$ steht und die andere der Gruppen $Y^1$ bzw. $Y^2$ für NR steht oder in denen beide Gruppen $Y^1$ und $Y^2$ für NR stehen oder in denen beide Gruppen $Y^1$ und $Y^2$ für O stehen.

Wenn $Y^1$ bzw. $Y^2$ für NR steht, steht der Substituent R, der an dieses Stickstoffatom gebunden ist, bevorzugt für ein aromatisches oder heteroaromatisches Ringsystem mit 5 bis 24 aromatischen Ringatomen, welches auch durch einen oder mehrere Reste $R^1$ substituiert sein kann. In einer besonders bevorzugten Ausführungsform steht dieser Substituent R gleich oder verschieden bei jedem Auftreten für ein aromatisches oder heteroaromatisches Ringsystem mit 6 bis 24 aromatischen Ringatomen, welches keine kondensierten Arylgruppen aufweist und welches keine kondensierten Heteroarylgruppen, in welchen zwei oder mehr aromatische bzw. heteroaromatische 6-Ring-Gruppen direkt aneinander ankondensiert sind, aufweist und welches jeweils auch durch einen oder mehrere Reste $R^1$ substituiert sein kann. Dabei enthalten die aromatischen bzw. heteroaromatischen Ringsysteme bevorzugt keine kondensierten Aryl-

bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. So ist es bevorzugt, wenn R beispielsweise keine Naphthylgruppen oder höhere kondensierte Arylgruppen aufweist und ebenso keine Chinolingruppen, Acridingruppen, etc.. Dagegen ist es möglich, dass R beispielsweise Carbazolgruppen, Dibenzofurangruppen, etc. aufweist, weil in diesen Strukturen keine 6-Ring-Aromaten bzw. -Heteroaromaten direkt aneinander ankondensiert sind. Bevorzugte Substituenten R sind ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3-oder 4-Fluorenyl, 1-, 2-, 3-oder 4-Spirobifluorenyl, 1- oder 2-Naphthyl, Pyrrol, Furan, Thiophen, Indol, Benzofuran, Benzothiophen, 1-, 2- oder 3-Carbazol, 1-, 2- oder 3-Dibenzofuran, 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren oder Kombinationen aus zwei oder drei dieser Gruppen, welche jeweils mit einem oder mehreren Resten $R^1$ substituiert sein können.

Wenn $Y^1$ bzw. $Y^2$ für $CR_2$ steht, steht R bevorzugt gleich oder verschieden bei jedem Auftreten für eine lineare Alkylgruppe mit 1 bis 10 C-Atomen oder für eine verzweigte oder cyclische Alkylgruppe mit 3 bis 10 C-Atomen oder für ein aromatisches oder heteroaromatisches Ringsystem mit 5 bis 24 aromatischen Ringatomen, welches auch durch einen oder mehrere Reste $R^1$ substituiert sein kann. Dabei können die Reste R auch ein Ringsystem miteinander bilden und so ein Spirosystem aufspannen. Ganz besonders bevorzugt steht R für eine Methylgruppe oder für eine Phenylgruppe. Dabei kann durch Ringbildung der Phenylgruppen auch ein Spirosystem entstehen.

In einer bevorzugten Ausführungsform der Erfindung steht mindestens eine der Gruppen $Y^1$ und $Y^2$ für NR, und die entsprechende Gruppe R steht für ein aromatisches oder heteroaromatisches Ringsystem, wie oben beschrieben. In diesem Fall kann es auch bevorzugt sein, wenn alle Substituenten R, die am Grundgerüst der Verbindung gemäß Formel (1) bzw. den bevorzugten Ausführungsformen gebunden sind, für H stehen.

In einer weiteren bevorzugten Ausführungsform der Verbindung gemäß Formel (1) oder den oben ausgeführten bevorzugten Ausführungsformen steht mindestens ein Substituent R, der am Grundgerüst der Verbindung gemäß Formel (1) gebunden ist, für einen Rest ungleich H oder D. Insbesondere ist mindestens einer der in den Formeln (3a) bis (9a) explizit eingezeichneten Reste R ungleich H oder D.

Dieser Substituent R ungleich H oder D steht bevorzugt für ein aromatisches oder heteroaromatisches Ringsystem mit 5 bis 24 aromatischen Ringatomen, welches auch durch einen oder mehrere Reste $R^1$ substituiert sein kann. In einer besonders bevorzugten Ausführungsform steht dieser Substituent R gleich oder verschieden bei jedem Auftreten für ein aromatisches oder heteroaromatisches Ringsystem mit 6 bis 24 aromatischen Ringatomen, welches keine kondensierten Arylgruppen aufweist und welches keine kondensierten Heteroarylgruppen, in welchen zwei oder mehr aromatische bzw. heteroaromatische 6-Ring-Gruppen direkt aneinander ankondensiert sind, aufweist und welches jeweils auch durch einen oder mehrere Reste $R^1$ substituiert sein kann. Besonders bevorzugt enthalten sie überhaupt keine Aryl- bzw. Heteroarylgruppen, in denen aromatische Sechsringe direkt aneinander ankondensiert sind. So ist es bevorzugt, wenn R beispielsweise keine Naphthylgruppen oder höhere kondensierte Arylgruppen aufweist und ebenso keine Chinolingruppen, Acridingruppen, etc.. Dagegen ist es möglich, dass R beispielsweise Carbazolgruppen, Dibenzofurangruppen, etc. aufweist, weil in diesen Strukturen keine 6-Ring-Aromaten bzw. -Heteroaromaten direkt aneinander ankondensiert sind. Bevorzugte Substituenten R sind ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1- oder 2-Naphthyl, Pyrrol, Furan, Thiophen, Indol, Benzofuran, Benzothiophen, 1-, 2- oder 3-Carbazol, 1-, 2- oder 3-Dibenzofuran, 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren oder Kombinationen aus zwei oder drei dieser Gruppen, welche jeweils mit einem oder mehreren Resten $R^1$ substituiert sein können.

In einer bevorzugten Ausführungsform der Erfindung treten die oben genannten Bevorzugungen gleichzeitig auf. Bevorzugt sind also die Verbindungen der Formeln (3a) bis (9a), in denen $Y^1$ und $Y^2$ gleich oder verschieden bei jedem Auftreten ausgewählt sind aus $CR_2$, NR, O oder S, insbesondere in den oben genannten Kombinationen, und in denen für R die oben genannten Bevorzugungen gelten.

Beispiele für bevorzugte Verbindungen gemäß Formel (1) sind die in der folgenden Tabelle aufgeführten Verbindungen.

| | | |
|---|---|---|
| 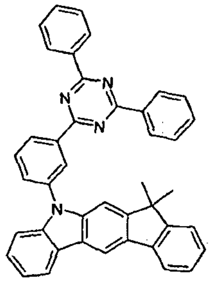 | 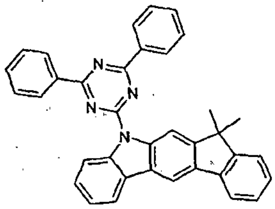 | 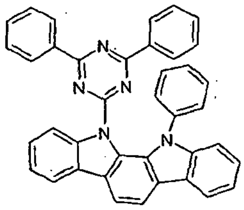 |
| 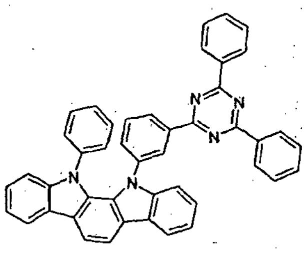 | 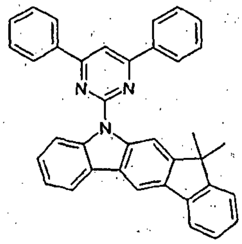 | 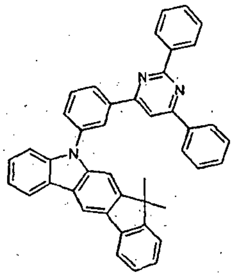 |
| 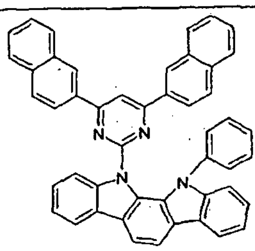 | 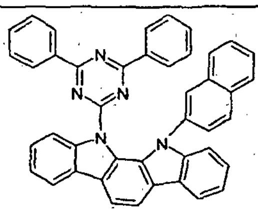 | 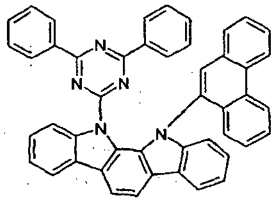 |
| 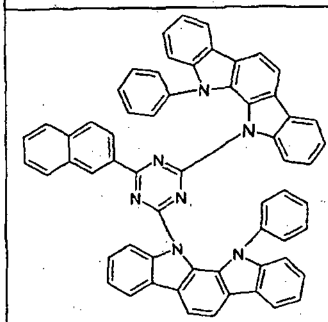 | 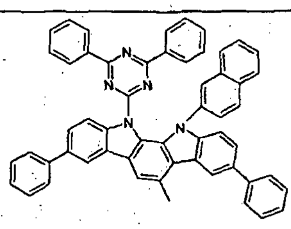 | 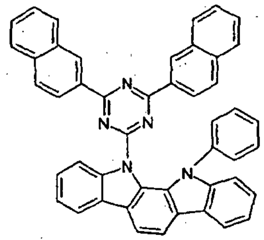 |
| 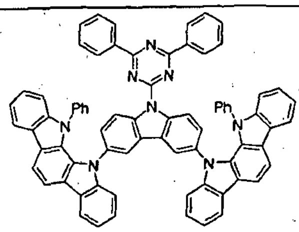 | 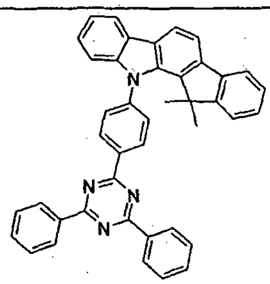 | 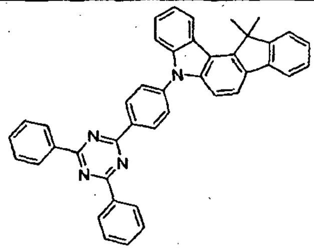 |

| | | |
|---|---|---|
| 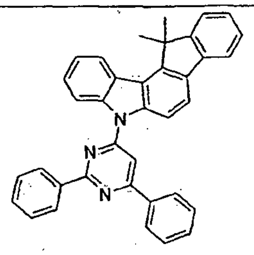 | 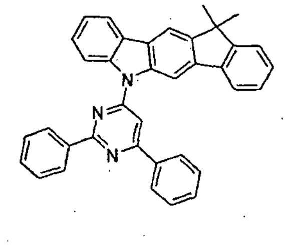 | 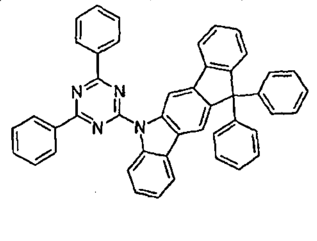 |
| 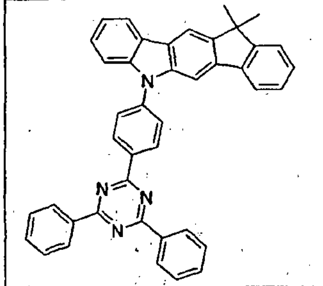 | 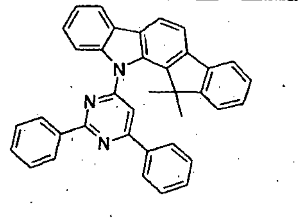 | 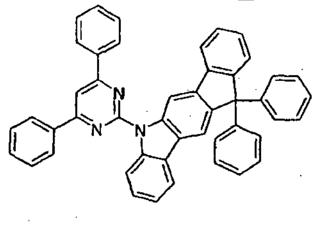 |
| 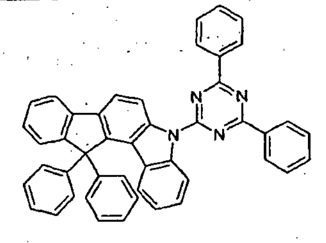 | 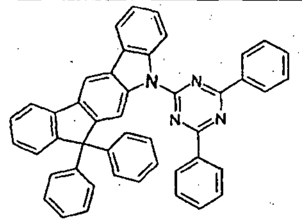 | 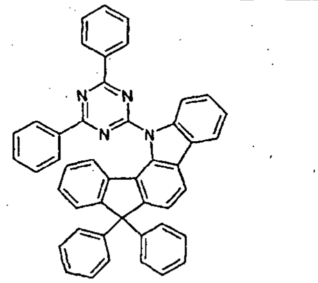 |
| 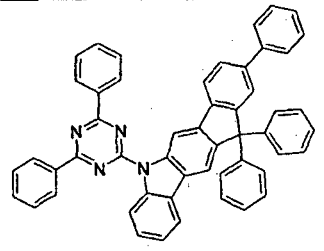 | 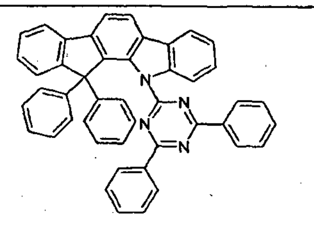 | 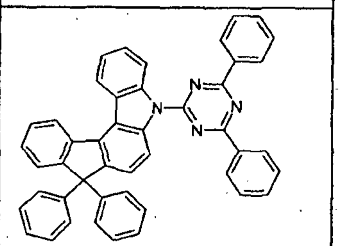 |
| 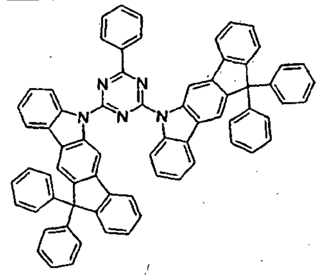 | 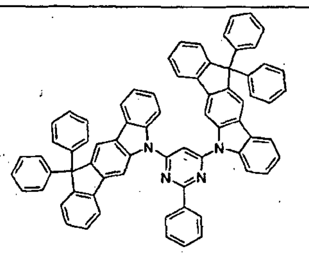 | 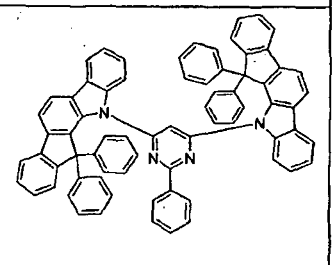 |
| 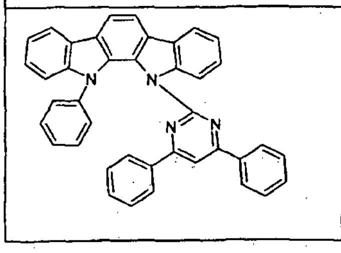 | 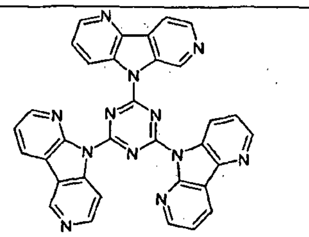 | 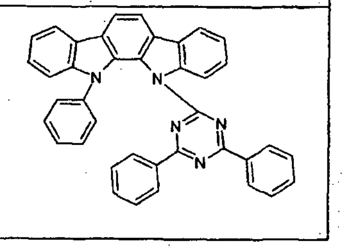 |

| | | |
|---|---|---|
| 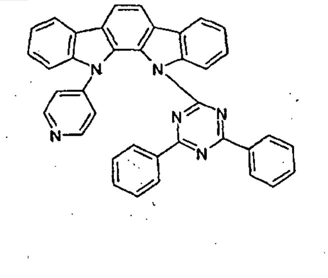 | 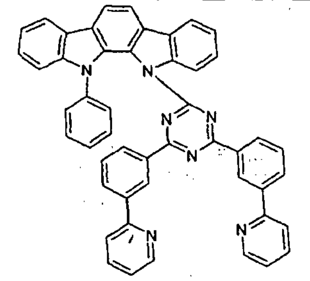 | 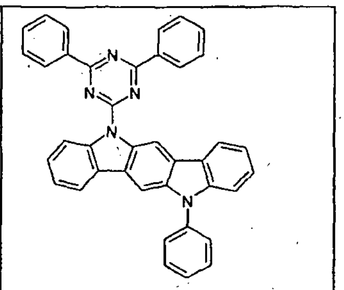 |
| 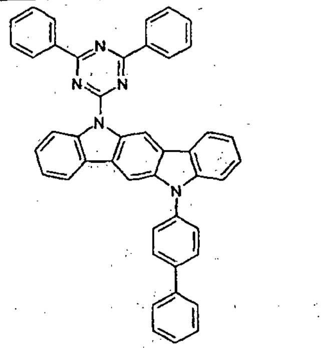 | 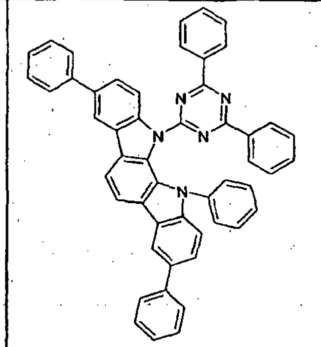 | 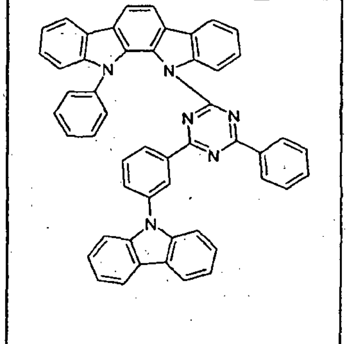 |
| 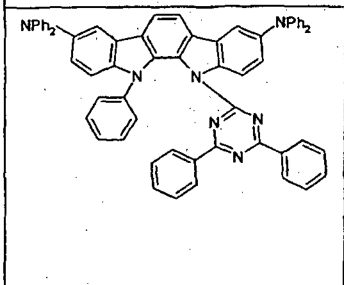 | 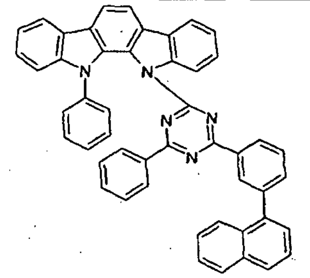 | 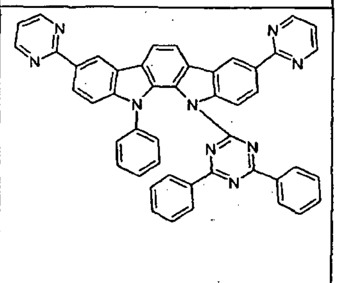 |
| 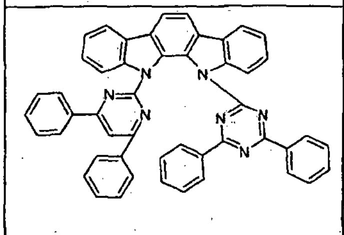 | 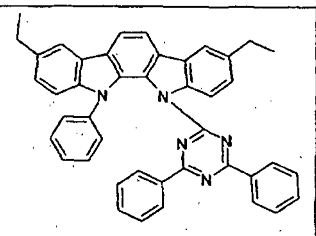 | 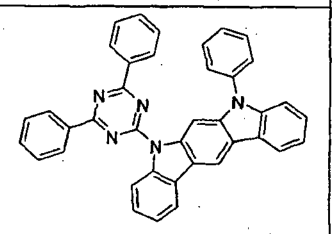 |
| 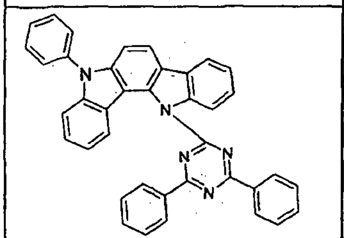 | 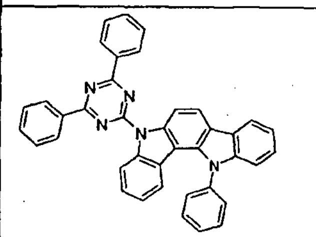 | 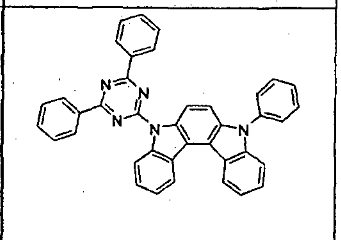 |
| 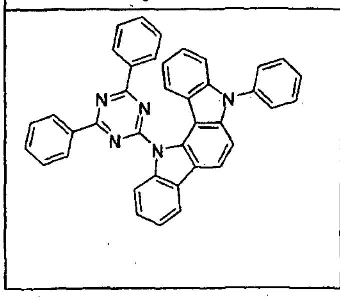 | 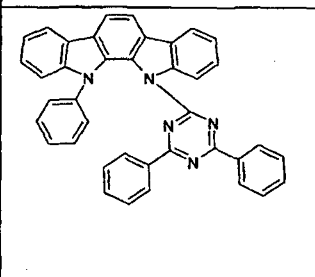 | 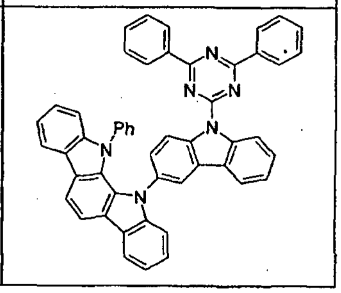 |

| | | |
|---|---|---|
| 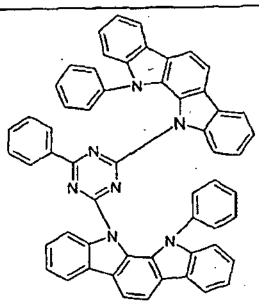 | 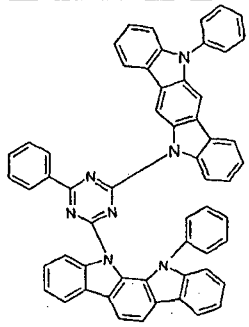 | 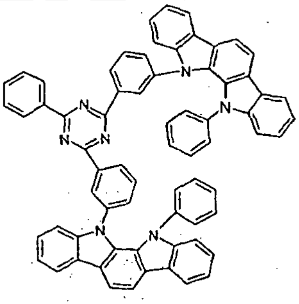 |
| 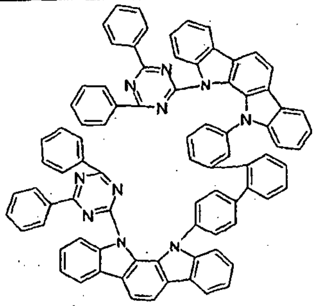 | 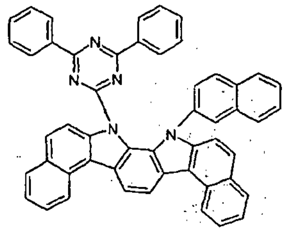 | 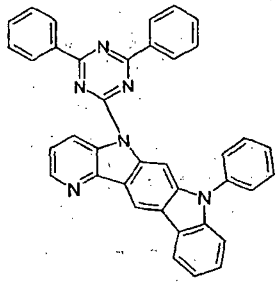 |
| 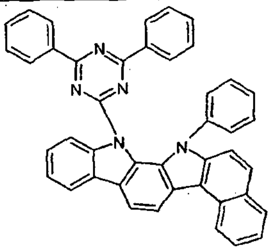 | 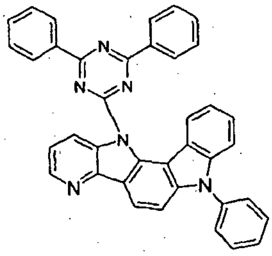 | 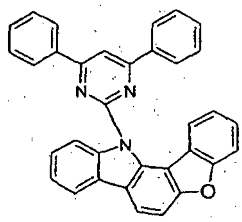 |
| 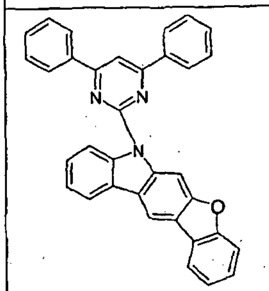 | 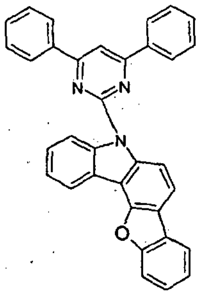 | 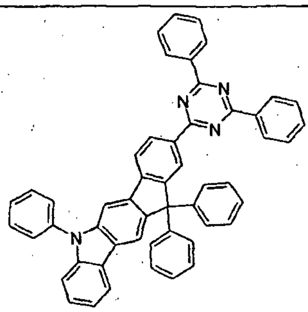 |
| 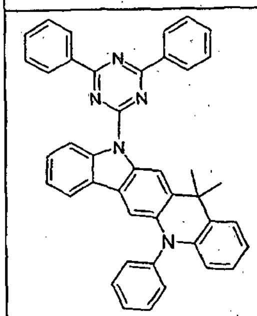 | 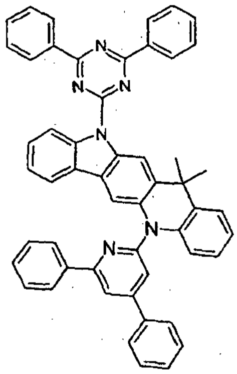 | 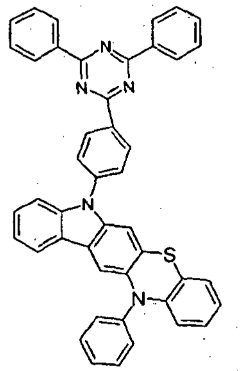 |

| | | |
|---|---|---|
| 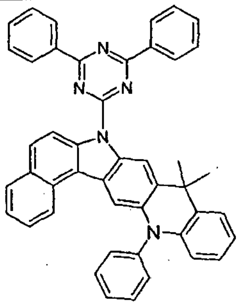 | 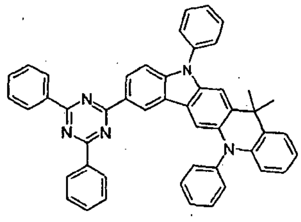 | 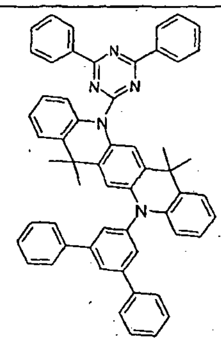 |
| 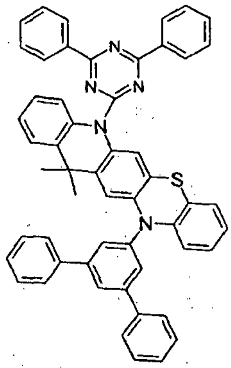 | 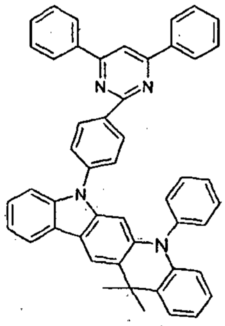 | 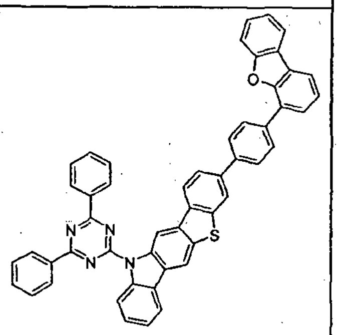 |
| 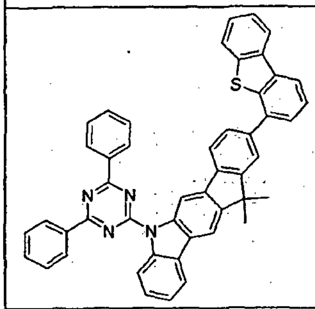 | 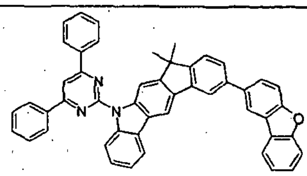 | 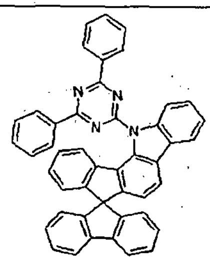 |
| 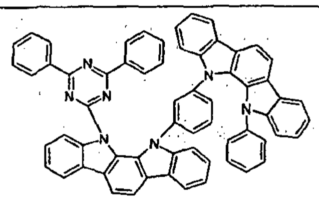 | 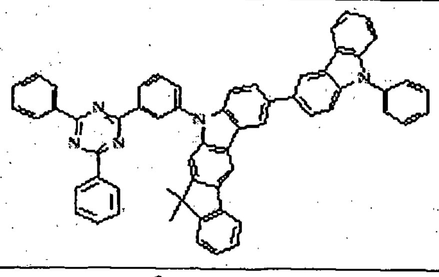 | |
| 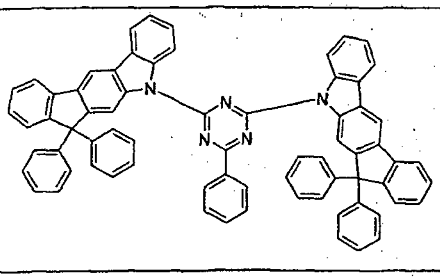 | 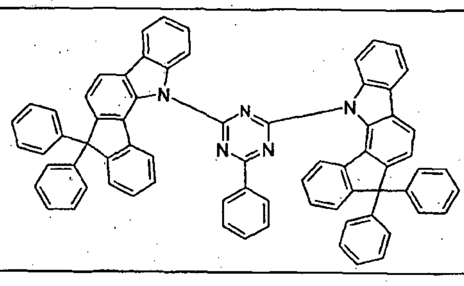 | |

| | | |
|---|---|---|
| 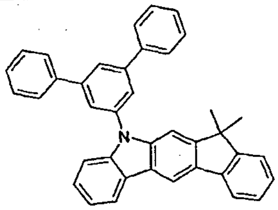 | 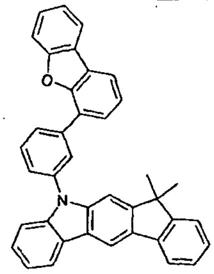 | 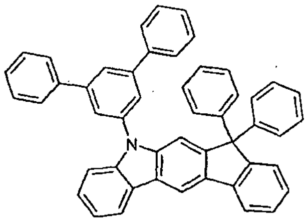 |
| 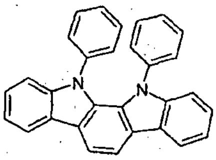 | 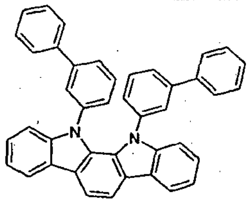 | 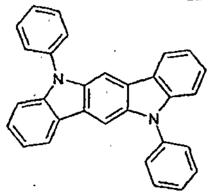 |
| 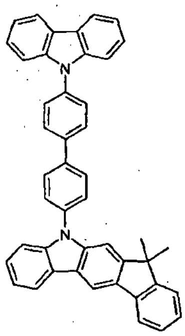 | 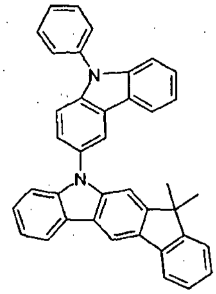 | 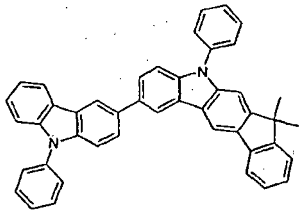 |
| 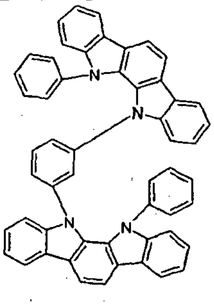 | 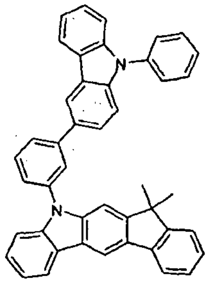 | 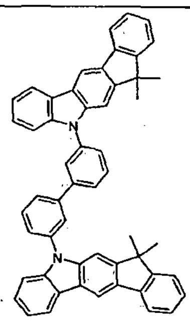 |
| 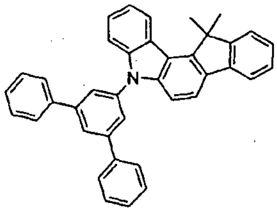 | 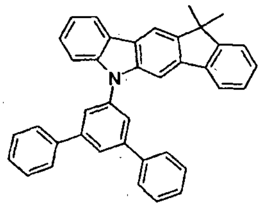 | 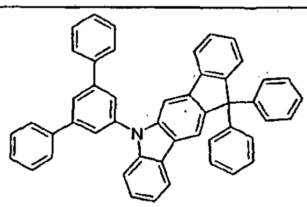 |
| 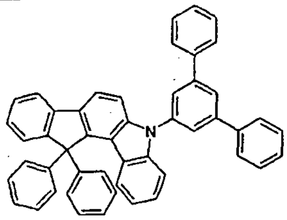 | 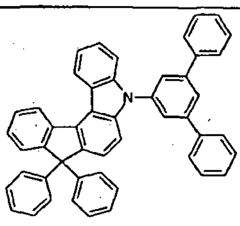 | 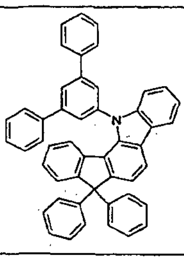 |

| | | |
|---|---|---|
| 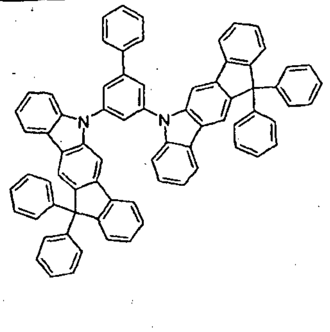 | 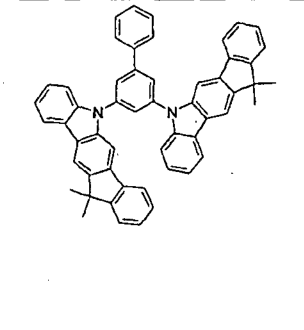 | 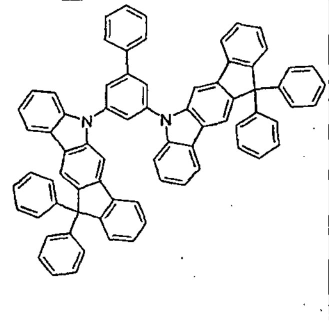 |
| 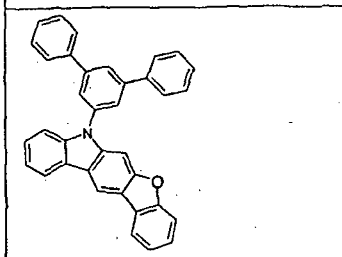 | 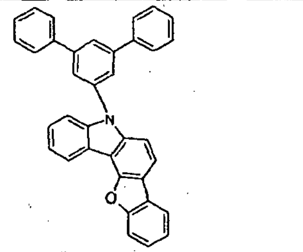 | 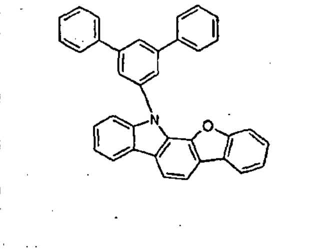 |
| 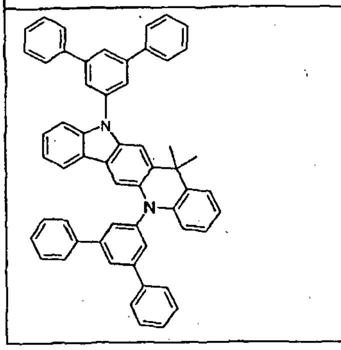 | 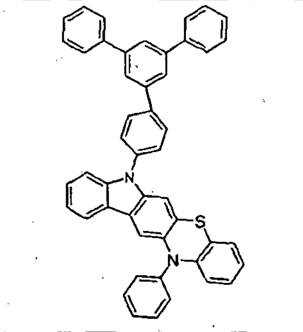 | 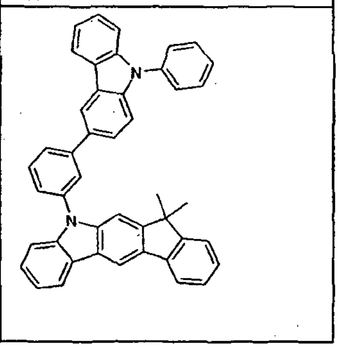 |

Im Folgenden wird die organische Elektrolumineszenzvorrichtung näher beschrieben.

Die organische Elektrolumineszenzvorrichtung enthält Kathode, Anode und eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Es sei aber darauf hingewiesen, dass nicht notwendigerweise jede dieser Schichten vorhanden sein muss.

In den weiteren Schichten der erfindungsgemäßen organischen Elektrolumineszenzvorrichtung, insbesondere in den Lochinjektions- und -transportschichten und in den Elektroneninjektions- und -transportschichten, können alle Materialien verwendet werden, wie sie üblicherweise gemäß dem Stand der Technik eingesetzt werden. Dabein können die Lochtransportschichten auch p-dotiert bzw. die Elektronentransportschichten auch n-dotiert sein. Dabei wird unter einer p-dotierten Schicht eine Schicht verstanden, in der freie Löcher erzeugt werden und deren Leitfähigkeit dadurch erhöht ist. Eine umfassende Diskussion von dotierten Transportschichten in OLEDs findet sich in Chem. Rev. 2007, 107, 1233. Besonders bevorzugt ist der p-Dotand in der Lage, das Lochtransportmaterial in der Lochtransportschicht zu oxidieren, hat also ein ausreichend hohes Redoxpotential, insbesondere ein höheres Redoxpotential als das Lochtransportmaterial. Als Dotanden sind prinzipiell alle Verbindungen geeignet, welche Elektronenakzeptorverbindungen darstellen und die Leitfähigkeit der organischen Schicht durch Oxidation des Hosts erhöhen können. Der Fachmann kann im Rahmen seines allgemeinen Fachwissens ohne größeren Aufwand geeignete Verbindungen identifizieren. Insbesondere geeignet als Dotanden sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709 und US 2010/0096600 offenbarten Verbindungen.

Der Fachmann kann daher ohne erfinderisches Zutun alle für organische Elektrolumineszenzvorrichtungen bekannten Materialien in Kombination mit der erfindungsgemäßen emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich

zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $Cs_2CO_3$, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/$NiO_x$, Al/$PtO_x$) bevorzugt sein. Dabei muss mindestens eine der Elektroden transparent oder teiltransparent sein, um die Auskopplung von Licht zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber auch möglich, dass der Anfangsdruck noch geringer ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden. Diese Verfahren eignen sich insbesondere auch für Oligomere, Dendrimere und Polymere.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Ein weiterer Gegenstand der vorliegenden Erfindung ist daher ein Verfahren zur Herstellung einer erfindungsgemäßen organischen Elektrolumineszenzvorrichtung, dadurch gekennzeichnet, dass mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

Die erfindungsgemäßen organischen Elektrolumineszenzvorrichtungen zeichnen sich durch einen oder mehrere der folgenden überraschenden Vorteile gegenüber dem Stand der Technik aus:

1. Die erfindungsgemäßen organischen Elektrolumineszenzvorrichtungen weisen eine sehr gute und gegenüber Vorrichtungen gemäß dem Stand der Technik, die ebenfalls TADF zeigen, eine verbesserte Effizienz auf.

2. Die erfindungsgemäßen organischen Elektrolumineszenzvorrichtungen weisen eine sehr geringe Spannung auf.

3. Die erfindungsgemäßen organischen Elektrolumineszenzvorrichtungen weisen eine sehr gute und gegenüber Vorrichtungen gemäß dem Stand der Technik, die ebenfalls TADF zeigen, eine verbesserte Lebensdauer auf.

4. Die erfindungsgemäßen organischen Elektrolumineszenzvorrichtungen weisen ein verbessertes Roll-Off-Verhalten auf, also einen geringeren Abfall der Effizienz bei hohen Leuchtdichten.

5. Im Vergleich zu organischen Elektrolumineszenzvorrichtungen gemäß dem Stand der Technik, die Iridium- oder Platinkomplexe als emittierende Verbindungen enthalten, weisen die erfindungsgemäßen Elektrolumineszenzvorrichtungen eine verbesserte Lebensdauer bei erhöhter Temperatur auf.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße organische Elektrolumineszenzvorrichtungen herstellen.

**Beispiele:**

**Bestimmung von HOMO, LUMO, Singulett- und Triplettniveau**

Die HOMO- und LUMO-Energieniveaus sowie die Energie des niedrigsten Triplettzustands $T_1$ bzw. des niedrigsten angeregten Singulettzustands $S_1$ der Materialien werden über quantenchemische Rechnungen bestimmt. Hierzu wird das Programmpaket "Gaussian09W" (Gaussian Inc.) verwendet. Zur Berechnung organischer Substanzen ohne Metalle (in Tabelle 4 mit Methode "org." bezeichnet) wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31G(d)" verwendet (Charge 0, Spin Singlet). Für metallhaltige Verbindungen (in Tabelle 4 mit Methode "M-org." bezeichnet) wird die Geometrie über die Methode "Ground State/Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

In Tabelle 4 sind die HOMO- und LUMO-Energieniveaus sowie $S_1$ und $T_1$ der verschiedenen Materialien angegeben.

**Bestimmung der PL-Quanteneffizienz (PLQE)**

Von den in den verschiedenen OLEDs verwendeten Emissionsschichten wird ein 50 nm dicker Film auf ein geeignetes transparentes Substrat, vorzugsweise Quarz, aufgebracht, d. h. die Schicht enthält dieselben Materialien in derselben Konzentration wie in der OLED. Hierbei werden die gleichen Herstellungsbedingungen wie bei der Herstellung der Emissionsschicht für die OLEDs verwendet. Von diesem Film wird ein Absorptionsspektrum im Wellenlängenbereich von 350-500 nm gemessen. Hierzu wird das Reflexionsspektrum $R(\lambda)$ sowie das Transmissionsspektrum $T(\lambda)$ der Probe unter einem Einfallswinkel von 6° (also nahezu senkrechter Einfall) bestimmt. Als Absorptionsspektrum im Sinne dieser Anmeldung wird $A(\lambda)=1-R(\lambda)-T(\lambda)$ definiert.

Gilt $A(\lambda) \leq 0.3$ im Bereich 350-500nm, so wird die zum Maximum des Absorptionsspektrums gehörige Wellenlänge im Bereich 350-500 nm als $\lambda_{exc}$ definiert. Gilt für irgendeine Wellenlänge $A(\lambda) > 0.3$, so wird als $\lambda_{exc}$ die größte Wellenlänge definiert, bei der $A(\lambda)$ von einem Wert kleiner 0.3 zu einem Wert größer 0.3 oder von einem Wert größer 0.3 zu einem Wert kleiner 0.3 wechselt.

Zur Bestimmung der PLQE wird ein Messplatz Hamamatsu C9920-02 verwendet. Das Prinzip beruht auf der Anregung der Probe mit Licht definierter Wellenlänge und der Messung der absorbierten und emittierten Strahlung. Die Probe befindet sich während der Messung in einer Ulbrichtkugel ("integrating sphere"). Das Spektrum des Anreguhgslichts ist in etwa gaußförmig mit einer Halbwertsbreite < 10 nm und Peakwellenlänge $\lambda_{exc}$ wie oben definiert.

Die PLQE wird nach dem für den genannten Messplatz üblichen Auswerteverfahren bestimmt. Es ist strengstens darauf zu achten, dass die Probe zu keinem Zeitpunkt mit Sauerstoff in Berührung kommt, da die PLQE von Materialien mit kleinem energetischen Abstand zwischen $S_1$ und $T_1$ durch Sauerstoff sehr stark reduziert wird (H. Uoyama et al.,

Nature 2012, Vol. 492, 234).

In Tabelle 2 ist die PLQE für die Emissionsschichten der OLEDs wie oben definiert zusammen mit der verwendeten Anregungswellenlänge angegeben.

**Bestimmung der Abklingzeit**

Zur Bestimmung der Abklingzeit wird eine Probe verwendet, die wie oben unter "Bestimmung der PL-Quanteneffizienz (PLQE)" beschrieben hergestellt wird. Die Probe wird bei einer Temperatur von 295 K durch einen Laserpuls angeregt (Wellenlänge 266 nm, Pulsdauer 1.5 ns, Pulsenergie 200 μJ, Strahldurchmesser 4 mm). Die Probe befindet sich hierbei im Vakuum (<$10^{-5}$ mbar). Nach der Anregung (definiert als t = 0) wird der zeitliche Verlauf der Intensität der emittierten Photolumineszenz gemessen. Die Photolumineszenz zeigt am Anfang einen steilen Abfall, der auf die prompte Fluoreszenz der TADF-Verbindung zurückzuführen ist. Im weiteren zeitlichen Verlauf ist ein langsamerer Abfall zu beobachten, die verzögerte Fluoreszenz (siehe z. B. H. Uoyama et al., Nature, vol. 492, no. 7428, pp. 234-238, 2012 sowie K. Masui et al., Organic Electronics, vol. 14, no. 11, pp. 2721-2726, 2013). Die Abklingzeit $t_a$ im Sinne dieser Anmeldung ist die Abklingzeit der verzögerten Fluoreszenz und wird wie folgt bestimmt: Man wählt einen Zeitpunkt $t_d$, zu dem die prompte Fluoreszenz deutlich unter die Intensität der verzögerten Fluoreszenz abgeklungen ist (<1%), so dass die folgende Bestimmung der Abklingzeit davon nicht beeinflusst wird. Diese Wahl kann von einem Fachmann durchgeführt werden. Für die Messdaten ab dem Zeitpunkt $t_d$ wird die Abklingzeit $t_a = t_e - t_d$ bestimmt. Dabei ist $t_e$ derjenige Zeitpunkt nach $t = t_d$, bei dem die Intensität erstmals auf 1/e ihres Wertes bei $t = t_d$ abgefallen ist.

Tabelle 2 zeigt die Werte von $t_a$ und $t_d$, die für die Emissionsschichten der erfindungsgemäßen OLEDs ermittelt werden.

**Beispiele: Herstellung der OLEDs**

In den folgenden Beispielen V1 bis E17 (siehe Tabellen 1 und 2) werden die Daten verschiedener OLEDs vorgestellt.

Glasplättchen, die mit strukturiertem ITO (Indium Zinn Oxid) der Dicke 50 nm beschichtet sind, bilden die Substrate für die OLEDs. Die Substrate werden nass gereinigt (Spülmaschine, Reiniger Merck Extran), anschließend 15 min lang bei 250 °C ausgeheizt und vor der Beschichtung 130s lang mit einem Sauerstoffplasma behandelt. Diese mit Plasma behandelten Glasplättchen bilden die Substrate, auf welche die OLEDs aufgebracht werden. Die Substrate verbleiben vor der Beschichtung im Vakuum. Die Beschichtung beginnt spätestens 10 min nach der Plasmabehandlung.

Die OLEDs haben prinzipiell folgenden Schichtaufbau: Substrat/ Lochinjektionsschicht (HIL) / Lochtransportschicht (HTL) / optionale Zwischenschicht (IL) / Elektronenblockerschicht (EBL) / Emissionsschicht (EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 3 gezeigt:

Alle Materialien werden in einer Vakuumkammer thermisch aufgedampft. Dabei besteht die Emissionsschicht immer aus einem Matrixmaterial (Hostmaterial, Wirtsmaterial) und der emittierenden TADF-Verbindung, also dem Material, das einen kleinen energetischen Abstand zwischen $S_1$ und $T_1$ zeigt. Dieses wird dem Matrixmaterial durch Coverdampfung in einem bestimmten Volumenanteil beigemischt. Eine Angabe wie IC1:D1 (95%:5%) bedeutet hierbei, dass das Material IC1 in einem Volumenanteil von 95% und D1 in einem Anteil von 5% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 2 bezeichnet die Spannung, die für eine Leuchtdichte von 1000 cd/$m^2$ benötigt wird. SE1000 und LE1000 bezeichnen die Strom- bzw. Leistungseffizienz, die bei 1000 cd/$m^2$ erreicht werden. EQE1000 schließlich bezeichnet die externe Quanteneffizienz bei einer Betriebsleuchtdichte von 1000 cd/$m^2$.

Der Roll-off wird definiert als EQE bei 5000 cd/$m^2$ geteilt durch EQE bei 500 cd/$m^2$, d.h. ein hoher Wert entspricht einem geringen Abfall der Effizienz bei hohen Leuchtdichten, was vorteilhaft ist.

Als Lebensdauer LD wird die Zeit definiert, nach der die Leuchtdichte bei Betrieb mit konstantem Strom von der Startleuchtdichte auf einen gewissen Anteil L1 absinkt. Eine Angabe von j0 = 10mA/$cm^2$, L1 = 80% in Tabelle 2 bedeutet, dass die Leuchtdichte bei Betrieb mit 10 mA/$cm^2$ nach der Zeit LD auf 80% ihres Anfangswertes absinkt.

Als emittierender Dotand in der Emissionsschicht wird die Verbindung D1 eingesetzt, die einen energetischen

Abstand zwischen $S_1$ und $T_1$ von 0.09 eV aufweist oder die Verbindung D2, für die Differenz zwischen $S_1$ und $T_1$ 0.06eV beträgt

Die Daten der verschiedenen OLEDs sind in Tabelle 2 zusammengefasst. Die Beispiele V1-V10 sind Vergleichsbeispiele gemäß dem Stand der Technik, die Beispiele E1-E17 zeigen Daten von erfindungsgemäßen OLEDs.

Im Folgenden werden einige der Beispiele näher erläutert, um die Vorteile der erfindungsgemäßen Verbindungen zu verdeutlichen. Es sei jedoch darauf hingewiesen, dass dies nur eine Auswahl der in Tabelle 2 gezeigten Daten darstellt.

Wie sich der Tabelle entnehmen lässt, erhält man mit erfindungsgemäßen Emissionsschichten deutliche Verbesserungen bezüglich Spannung und Effizienz, was zu einer deutlichen Verbesserung der Leistungseffizienz führt. Z.B erhält man mit Verbindung IC1 im Vergleich zu CBP eine um 0.6 V niedrigere Betriebsspannung, eine ca. 45% bessere Quanteneffizienz und eine etwa 70% bessere Leistungseffizienz, gleichzeitig verbessert sich der Roll-Off deutlich von 0.60 auf 0.72 (Beispiele V2, E2).

Weiterhin erhält man mit erfindungsgemäßen Emissionsschichten deutlich bessere Lebensdauern der OLEDs. Gegenüber CBP als Matrixmaterial erhöht sich die Lebensdauer bei Einsatz von IC1 um ca. 80% (Beispiele V2, E2), bei Einsatz von IC5 im gleichen Aufbau sogar um 140% (Beispiele V2, E4).

Tabelle 1: Aufbau der OLEDs

| Bsp | HIL Dicke | HTL Dicke | IL Dicke | EBL Dicke | EML Dicke | HBL Dicke | ETL Dicke | EIL Dicke |
|---|---|---|---|---|---|---|---|---|
| V1 | HAT 5nm | SpA1 70nm | HAT 5nm | SpMA1 20nm | CBP:D1 (95%: 5%) 15nm | - | ST2:LiQ (50%: 50%) 50nm | |
| V2 | HAT 5nm | SpA1 70nm | HAT 5nm | SpMA1 20nm | CBP:D1 (95%: 5%) 15nm | IC1 10nm | ST2:LiQ (50%: 50%) 40nm | - |
| V3 | HAT 5nm | SpA1 70nm | HAT 5nm | SpMA1 20nm | BCP:D1 (95%: 5%) 15nm | IC1 10nm | ST2 40nm | LiQ 3nm |
| V4 | HAT 5nm | SpA1 70nm | HAT 5nm | SpMA1 20nm | BCP:D1 (95%: 5%) 15nm | BCP 10nm | ST2 40nm | LiQ 3nm |
| V5 | HAT 5nm | SpA1 70nm | HAT 5nm | SpMA1 20nm | BCP:D1 (95%: 5%) 15nm | IC5 10nm | ST2 40nm | LiQ 3nm |
| V6 | HAT 5nm | SpA1 70nm | HAT 5nm | SpMA1 20nm | CBP:D1 (95%: 5%) 30nm | IC1 10nm | ST2 40nm | LiQ 3nm |
| V7 | SpMA1:F4T (95%:5%) 10nm | SpMA1 80nm | --- | IC2 10nm | CBP:D1 (95%: 5%) 15nm | IC1 10nm | ST2:LiQ (50%: 50%) 40nm | - |
| V8 | --- | --- | --- | SpMA1 90nm | CBP:D2 (95%: 5%) 15nm | IC1 10nm | ST2 45nm | LiQ 3nm |
| V9 | --- | --- | --- | SPMA1 90nm | CBP:D2 (95%: 5%) 15nm | IC1 10nm | TPBI 45nm | LiQ 3nm |
| V10 | --- | --- | --- | SpMA1 90nm | CBP:D2 (90%: 10%) 15nm | IC1 10nm | ST2 45nm | LiQ 3nm |
| E1 | HAT 5nm | SpA1 70nm | HAT 5nm | SpMA1 20nm | IC1:D1 (95%: 5%) 15nm | - | ST2:LiQ (50%: 50%) 50nm | - |
| E2 | HAT 5nm | SpA1 70nm | HAT 5nm | SpMA1 20nm | IC1:D1 (95%: 5%) 15nm | IC1 10nm | ST2:LiQ (50%: 50%) 40nm | - |
| E3 | HAT 5nm | SpA1 70nm | HAT 5nm | SpMA1 20nm | IC5:D1 (95%: 5%) 15nm | --- | ST2:LiQ (50%: 50%) 50nm | --- |
| E4 | HAT 5nm | SpA1 70nm | HAT 5nm | SpMA1 20nm | IC5:D1 (95%: 5%) 15nm | IC1 10nm | ST2:LiQ (50%: 50%) 40nm | --- |
| E5 | HAT 5nm | SpA1 70nm | HAT 5nm | SpMA1 20nm | IC1:D1 (95%: 5%) 15nm | IC1 10nm | ST2 40nm | LiQ 3nm |

(fortgesetzt)

| Bsp | HIL Dicke | HTL Dicke | IL Dicke | EBL Dicke | EML Dicke | HBL Dicke | ETL Dicke | EIL Dicke |
|---|---|---|---|---|---|---|---|---|
| E6 | HAT 5nm | SpA1 70nm | HAT 5nm | SpMA1 20nm | IC1:D1 (95%: 5%) 15nm | BCP 10nm | ST2 40nm | LiQ 3nm |
| E7 | HAT 5nm | SpA1 70nm | HAT 5nm | SpMA1 20nm | IC1:D1 (95%: 5%) 15nm | IC5 10nm | ST2 40nm | LiQ 3nm |
| E8 | HAT 5nm | SpA1 70nm | HAT 5nm | SpMA1 20nm | IC1:D1(95%: 5%) 30nm | IC1 10nm | ST2 40nm | LiQ 3nm |
| E9 | SpMA1:F4T (95%:5%) 10nm | SpMA1 80nm | --- | IC2 10nm | IC1:D1 (95%: 5%) 15nm | IC1 10nm | ST2:LiQ (50%: 50%) 40nm | --- |
| E10 | HAT 5nm | SpA1 70nm | HAT 5nm | SpMA1 20nm | IC3:D1 (95%: 5%) 15nm | IC1 10nm | ST2:LiQ (50%: 50%) 40nm | --- |
| E11 | HAT 5nm | SpA1 70nm | HAT 5nm | SpMA1 20nm | IC4:D1 (95%: 5%) 15nm | IC1 10nm | ST2:LiQ (50%: 50%) 40nm | --- |
| E12 | --- | --- | --- | SpMA1 90nm | IC1:D2 (95%: 5%) 15nm | IC1 10nm | ST2 45nm | LiQ 3nm |
| E13 | --- | --- | --- | SpMA1 90nm | IC1:D2 (95%: 5%) 15nm | IC1 10nm | TPBI 45nm | LiQ 3nm |
| E14 | --- | --- | --- | SpMA1 90nm | IC1:D2 (90%: 10%) 15nm | IC1 10nm | ST2 45nm | LiQ 3nm |
| E15 | --- | --- | --- | SpMA1 90nm | IC6:D2 (95%: 5%) 15nm | IC1 10nm | ST2 45nm | LiQ 3nm |
| E16 | --- | --- | --- | SpMA1 90nm | IC6:D2 (95%: 5%) 15nm | IC1 10nm | TPBI 45nm | LiQ 3nm |
| E17 | --- | --- | --- | SpMA1 90nm | IC6:D2 (90%: 10%) 15nm | IC1 10nm | ST2 45nm | LiQ 3nm |

Tabelle 2: Daten der OLEDs

| Bsp | U1000 (V) | SE1000 (cd/A) | LE1000 (lm/W) | EQE 1000 | CIE x/y bei 1000 cd/m$^2$ | Roll-Off | L0;j0 | L1 % | LD (h) | PLQE % | $\lambda_{exc}$ nm | $t_d$ µs | $t_0$µs |
|---|---|---|---|---|---|---|---|---|---|---|---|---|---|
| V1 | 5.3 | 8.2 | 4.9 | 2.6% | 0.27/0.58 | 0.43 | 10mA/cm$^2$ | 90 | 107 | 100 | 350 | 7 | 4.5 |
| V2 | 4.2 | 44 | 33 | 14.1% | 0.25/0.58 | 0.60 | 10mA/cm$^2$ | 80 | 23 | 100 | 350 | 7 | 4.5 |
| V3 | 6.7 | 4.9 | 2.3 | 1.6% | 0.26/0.56 | 0.65 | 10mA/cm$^2$ | 80 | 1 | 59 | 350 | 6 | 5.9 |
| V4 | 7.8 | 4.2 | 1.7 | 1.4% | 0.27/0.55 | 0.63 | 10mA/cm$^2$ | 80 | 1 | 59 | 350 | 6 | 5.9 |
| V5 | 6.8 | 4.3 | 2.0 | 1.4% | 0.27/0.54 | 0.53 | 10mA/cm$^2$ | 80 | 1 | 59 | 350 | 6 | 5.9 |
| V6 | 5.1 | 44 | 27 | 13.6% | 0.27/0.58 | 0.73 | 10mA/cm$^2$ | 80 | 21 | 100 | 350 | 7 | 4.5 |
| V7 | 4.1 | 49 | 38 | 15.4% | 0.27/0.58 | 0.63 | 10mA/cm$^2$ | 80 | 34 | 100 | 350 | 7 | 4.5 |
| V8 | 8.1 | 20 | 7.6 | 6.7% | 0.49/0.49 | 0.64 | 10mA/cm$^2$ | 80 | 14 | 43 | 350 | 6 | 5.1 |
| V9 | 9.2 | 12.5 | 4.3 | 4.7% | 0.49/0.47 | 0.72 | 10mA/cm$^2$ | 80 | 5 | 43 | 350 | 6 | 5.1 |
| V10 | 8.1 | 14.6 | 5.7 | 6.3% | 0.54/0.45 | 0.71 | 10mA/cm$^2$ | 80 | 25 | 35 | 350 | 5 | 4.9 |
| E1 | 4.3 | 18.7 | 13.7 | 5.9% | 0.26/0.58 | 0.69 | 10mA/cm$^2$ | 90 | 131 | 92 | 350 | 7 | 5.4 |
| E2 | 3.6 | 65 | 56 | 20.8% | 0.25/0.58 | 0.72 | 10mA/cm$^2$ | 80 | 44 | 92 | 350 | 7 | 5.4 |
| E3 | 4.3 | 12.1 | 8.9 | 3.8% | 0.33/0.58 | 0.67 | 10mA/cm$^2$ | 90 | 178 | 57 | 350 | 4 | 4.0 |
| E4 | 3.5 | 43 | 39 | 13.3% | 0.32/0.58 | 0.66 | 10mA/cm$^2$ | 80 | 63 | 57 | 350 | 4 | 4.0 |
| E5 | 3.3 | 67 | 64 | 21.0% | 0.26/0.58 | 0.79 | 10mA/cm$^2$ | 80 | 28 | 92 | 350 | 7 | 5.4 |
| E6 | 4.1 | 17.2 | 13.2 | 5.4% | 0.26/0.58 | 0.69 | 10mA/cm$^2$ | 80 | 12 | 92 | 350 | 7 | 5.4 |
| E7 | 3.2 | 56 | 56 | 17.6% | 0.27/0.58 | 0.75 | 10mA/cm$^2$ | 80 | 22 | 92 | 350 | 7 | 5.4 |
| E8 | 3.9 | 65 | 53 | 20.1% | 0.27/0.59 | 0.79 | 10mA/cm$^2$ | 80 | 30 | 92 | 350 | 7 | 5.4 |
| E9 | 3.6 | 68 | 59 | 21.5% | 0.26/0.58 | 0.73 | 10mA/cm$^2$ | 80 | 52 | 92 | 350 | 7 | 5.4 |
| E10 | 3.2 | 52 | 52 | 15.7% | 0.31/0.60 | 0.71 | 10mA/cm$^2$ | 80 | 88 | 77 | 350 | 7 | 7.0 |
| E11 | 3.9 | 48 | 38 | 14.6% | 0.27/0.59 | 0.61 | 10mA/cm$^2$ | 80 | 38 | 84 | 359 | 7 | 4.2 |
| E12 | 5.3 | 27 | 16 | 9.6% | 0.51/0.48 | 0.80 | 10mA/cm$^2$ | 80 | 69 | 41 | 350 | 7 | 4.6 |
| E13 | 7.0 | 15.0 | 6.7 | 5.6% | 0.50/0.48 | 0.84 | 10mA/cm$^2$ | 80 | 15 | 41 | 350 | 7 | 4.6 |
| E14 | 5.9 | 16.2 | 8.6 | 7.3% | 0.55/0.44 | 0.80 | 10mA/cm$^2$ | 80 | 95 | 33 | 350 | 6 | 6.2 |
| E15 | 8.1 | 14.4 | 5.6 | 5.8% | 0.5210.46 | 0.77 | 10mA/cm$^2$ | 80 | 68 | 37 | 350 | 6 | 5.3 |

(fortgesetzt)

| Bsp | U1000 (V) | SE1000 (cd/A) | LE1000 (lm/W) | EQE 1000 | CIE x/y bei 1000 cd/m$^2$ | Roll-Off | L0;j0 | L1 % | LD (h) | PLQE % | $\lambda_{exc}$ nm | $t_d$ µs | $t_0$µs |
|---|---|---|---|---|---|---|---|---|---|---|---|---|---|
| E16 | 9.2 | 10.5 | 3.6 | 4.3% | 0.51/0.46 | 0.81 | 10mA/cm$^2$ | 80 | 26 | 37 | 350 | 6 | 5.3 |
| E17 | 8.0 | 12.7 | 5.0 | 5.7% | 0.54/0.44 | 0.80 | 10mA/cm$^2$ | 80 | 76 | 29 | 350 | 6 | 5.0 |

Tabelle 3: Strukturformeln der Materialien für die OLEDs

| | |
|---|---|
| 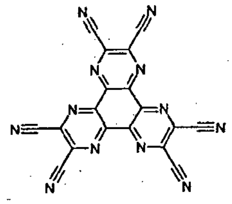 | 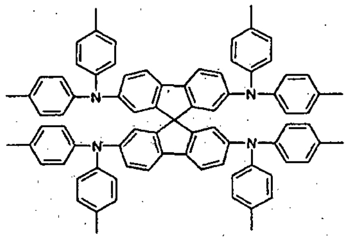 |
| HAT | SpA1 |
| 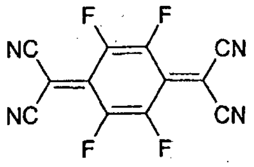 | 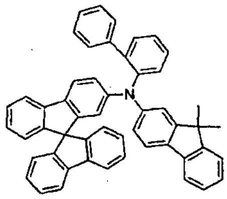 |
| F4T | SpMA1 |
| 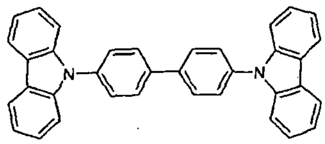 | 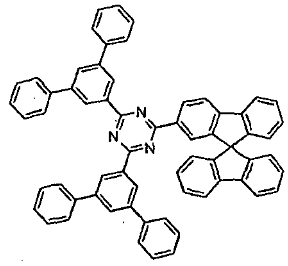 |
| CBP | ST2 |
| 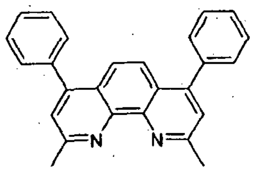 | 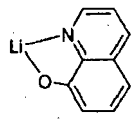 |
| BCP | LiQ |
| 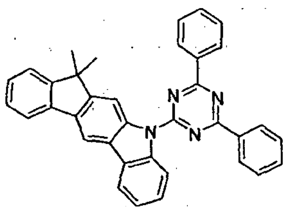 | 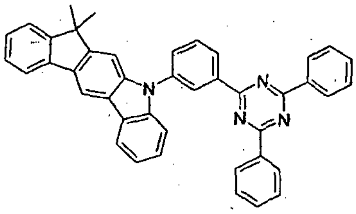 |
| IC1 | IC5 |
| 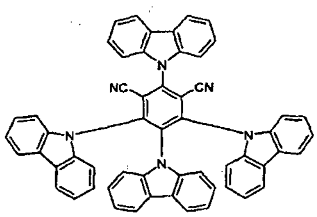 | 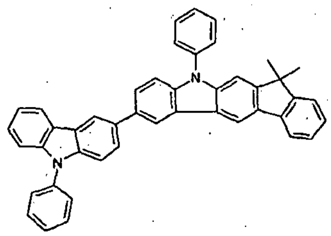 |
| D1 | IC2 |

(fortgesetzt)

| | |
|---|---|
| 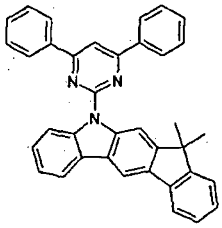 | 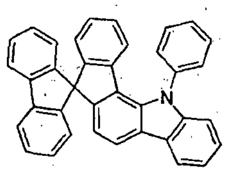 |
| IC3 | IC4 |
| 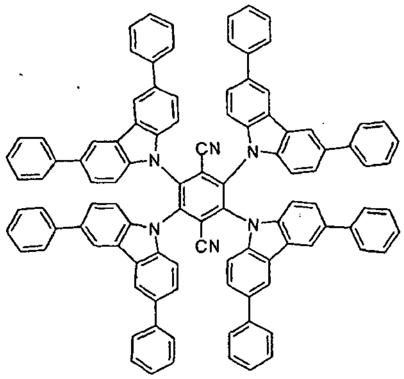 | 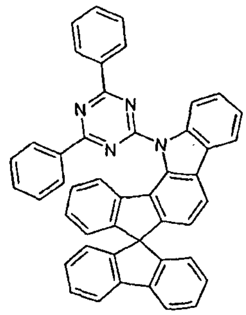 |
| D2 | IC6 |
| 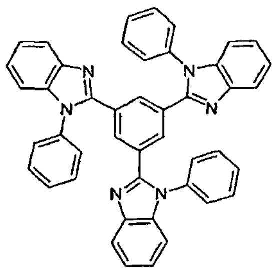 | |
| TPBI | |

Tabelle 4: HOMO, LUMO, $T_1$, $S_1$ der relevanten Materialien

| Material | Methode | HOMO (eV) | LUMO (eV) | $S_1$ (eV) | $T_1$ (eV) |
|---|---|---|---|---|---|
| D1 | orq. | -6.11 | -3.40 | 2.50 | 2.41 |
| D2 | org. | -5.92 | -3.61 | 2.09 | 2.03 |
| CBP | org. | -5.67 | -2.38 | 3.59 | 3.11 |
| BCP | org. | -6.15 | -2.44 | 3.61 | 2.70 |
| IC1 | org. | -5.79 | -2.83 | 3.09 | 2.69 |
| IC5 | orq. | -5.56 | -2.87 | 2.87 | 2.72 |
| IC4 | org. | -5.74 | -2.23 | 3.59 | 2.72 |
| IC3 | org. | -5.62 | -2.75 | 3.02 | 2.75 |
| SpA1 | orq. | -4.87 | -2.14 | 2.94 | 2.34 |
| SpMA1 | org. | -5.25 | -2.18 | 3.34 | 2.58 |
| IC2 | org. | -5.40 | -2.11 | 3.24 | 2.80 |

(fortgesetzt)

| Material | Methode | HOMO (eV) | LUMO (eV) | $S_1$ (eV) | $T_1$ (eV) |
|---|---|---|---|---|---|
| HAT | org. | -8.86 | -4.93 | | |
| F4T | org. | -7.91 | -5.21 | | |
| ST2 | org. | -6.03 | -2.82 | 3.32 | 2.68 |
| LiQ | M-org. | -5.17 | -2.39 | 2.85 | 2.13 |
| TPBI | org. | -6.26 | -2.48 | 3.47 | 3.04 |
| IC6 | org. | -5.87 | -2.85 | 2.72 | 3.14 |

**Patentansprüche**

**1.** Organische Elektrolumineszenzvorrichtung, enthaltend Kathode, Anode und emittierende Schicht, die die folgenden Verbindungen enthält:

(A) eine lumineszente organische Verbindung, die eine aromatische Verbindung ist, welche sowohl Donor- wie auch Akzeptorsubstituenten aufweist, wobei die Donorsubstituenten gewählt sind aus der Gruppe bestehend aus Diaryl- bzw. heteroarylaminogruppe, Carbazolgruppen und Carbazolderivaten, die jeweils auch substituiert sein können, und wobei die Akzeptorsubstituenten gewählt sind aus der Gruppe bestehend aus Cyanogruppen und elektronenarmen Heteroarylgruppen, die auch substituiert sein können, und die einen Abstand zwischen dem niedrigsten Triplettzustand $T_1$ und dem ersteh angeregten Singulettzustand $S_1$ von $\leq$ 0.15 eV aufweist (TADF-Verbindung); und
(B) eine Verbindung der Formel (1),

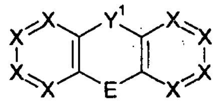

Formel (1)

wobei für die verwendeten Symbole gilt:

X ist bei jedem Auftreten gleich oder verschieden CR oder N, oder eine Gruppe X-X steht für eine Gruppe der folgenden Formel (2), mit der Maßgabe, dass mindestens eine Gruppe X-X für eine Gruppe der Formel (2) steht und dass pro Cyclus maximal eine Gruppe X-X für eine Gruppe der Formel (2) steht,

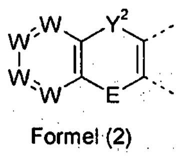

Formel (2)

wobei die C-Atome mit den gestrichelten Bindungen die Bindung der Gruppe andeuten;
$Y^1$, $Y^2$ ist bei jedem Auftreten gleich oder verschieden ausgewählt aus der Gruppe bestehend aus $CR_2$, NR, O, S, $SiR_2$, BR, PR und P(=O)R;
E ist bei jedem Auftreten gleich oder verschieden ausgewählt aus der Gruppe bestehend aus einer Einfachbindung, $CR_2$, NR, O, S, $SiR_2$, BR, PR und P(=O)R;
W ist bei jedem Auftreten gleich oder verschieden CR oder N;
R ist bei jedem Auftreten gleich oder verschieden ausgewählt aus der Gruppe bestehend aus H, D, F, Cl, Br, I, CN, $NO_2$, $N(Ar)_2$, $N(R^1)_2$, C(=O)Ar, C(=O)$R^1$, P(=O)$(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder

mehreren Resten $R^1$ substituiert sein kann, wobei eine oder mehrere nicht-benachbarte $CH_2$-Gruppen durch $R^1C=CR^1$ $C\equiv C$, $Si(R^1)_2$, C=O, C=S, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80 aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Aralkyl- oder Heteroaralkylgruppe mit 5 bis 60 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;
$R^1$ ist bei jedem Auftreten gleich oder verschieden ausgewählt aus der Gruppe bestehend aus H, D, F, Cl, Br, I, CN, $NO_2$, $N(Ar)_2$, $N(R^2)_2$, C(=O)Ar, $C(=O)R^2$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- öder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch $R^2C=CR^2$, $C\equiv C$, $Si(R^2)_2$, C=O, C=S, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder eine Aralkyl- oder Heteroaralkylgruppe mit 5 bis 60 aromatischen Ringatomen, wobei optional zwei oder mehr benachbarte Substituenten $R^1$ ein monocyclisches oder polycyclisches, aliphatisches, aromatisches oder heteroaromatisches Ringsystem bilden können, das mit einem oder mehreren Resten $R^2$ substituiert sein kann;
Ar ist bei jedem Auftreten gleich oder verschieden ein aromatisches oder heteroaromatisches Ringsystem mit 5-30 aromatischen Ringatomen, das mit einem oder mehreren nicht-aromatischen Resten $R^2$ substituiert sein kann; dabei können zwei Reste Ar, welche an dasselbe N-Atom oder P-Atom binden, auch durch eine Einfachbindung oder eine Brücke, ausgewählt aus $N(R^2)$, $C(R^2)_2$, O oder S, miteinander verbrückt sein;
$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können.

2. Organische Elektrolumineszenzvorrichtung nach Anspruch 1, **dadurch gekennzeichnet, dass** die TADF-Verbindung in einer Schicht in Mischung mit der Verbindung der Formel (1) eine Lumineszenzquanteneffizienz von mindestens 40 % aufweist

3. Organische Elektrolumineszenzvorrichtung nach Anspruch 1 oder 2, **dadurch gekennzeichnet, dass** der Abstand zwischen $S_1$ und $T_1$ der TADF-Verbindung $\leq$ 0.10 eV, bevorzugt $\leq$ 0.08 eV und besonders bevorzugt $\leq$ 0.05 eV ist.

4. Organische Elektrolumineszenzvorrichtung nach einem oder mehreren der Ansprüche 1 bis 3, **dadurch gekennzeichnet, dass** für das LUMO der TADF-Verbindung LUMO(TADF) und das HOMO der Verbindung der Formel (1) HOMO(Matrix) gilt:

$$\text{LUMO(TADF)} - \text{HOMO(Matrix)} > S_1\text{(TADF)} - 0.4 \text{ eV},$$

wobei $S_1$(TADF) der erste angeregte Singulettzustand $S_1$ der TADF-Verbindung ist.

5. Organische Elektrolumineszenzvorrichtung nach einem oder mehreren der Ansprüche 1 bis 4, **dadurch gekennzeichnet, dass** die niedrigste Triplettenergie der Verbindung der Formel (1) maximal 0.1 eV niedriger ist als die Triplettenergie der TADF-Verbindung.

6. Organische Elektrolumineszenzvorrichtung nach einem oder mehreren der Ansprüche 1 bis 5, **dadurch gekennzeichnet, dass** E bei jedem Auftreten gleich oder verschieden ausgewählt ist aus der Gruppe bestehend aus einer Einfachbindung, $CR_2$, NR, O oder S.

**7.** Organische Elektrolumineszenzvorrichtung nach einem oder mehreren der Ansprüche 1 bis 6, **dadurch gekennzeichnet, dass** die Verbindung der Formel (1) ausgewählt ist aus den Verbindungen der Formeln (3) bis (9),

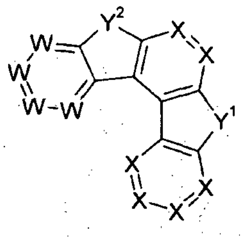
Formel (3)

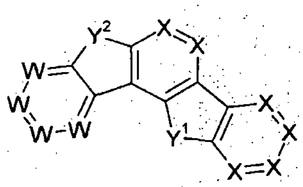
Formel (4)

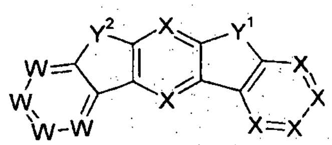
Formel (5)

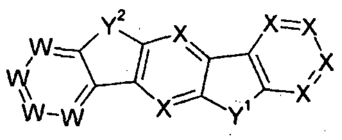
Formel (6)

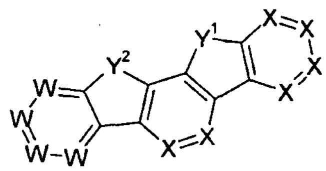
Formel (7)

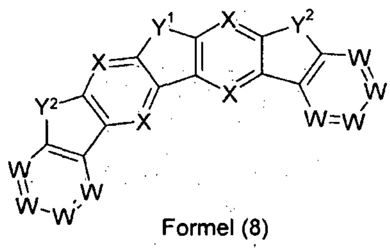
Formel (8)

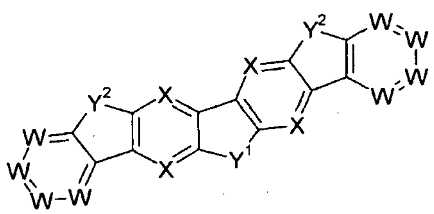
Formel (9)

wobei W, $Y^1$, $Y^2$, R, $R^1$ und $R^2$ die in Anspruch 1 genannten Bedeutungen aufweisen und weiterhin gilt:

X ist bei jedem Auftreten gleich oder verschieden CR oder N.

**8.** Organische Elektrolumineszenzvorrichtung nach einem oder mehreren der Ansprüche 1 bis 7, **dadurch gekennzeichnet, dass** maximal ein Symbol X pro Cyclus für N steht und dass maximal ein Symbol W pro Cyclus für N steht.

**9.** Organische Elektrolumineszenzvorrichtung nach einem oder mehreren der Ansprüche 1 bis 8, **dadurch gekennzeichnet, dass** die Verbindung der Formel (1) ausgewählt ist aus den Verbindungen der Formeln (3a) bis (9a),

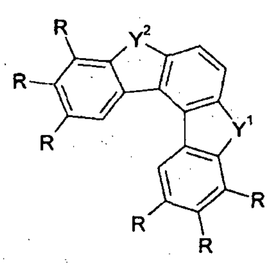
Formel (3a)

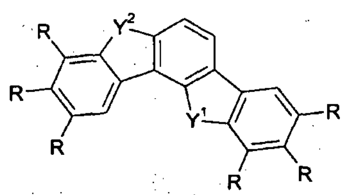
Formel (4a)

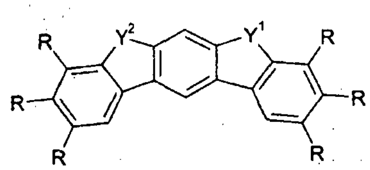
Formel (5a)

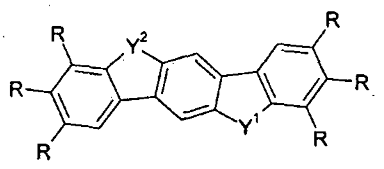
Formel (6a)

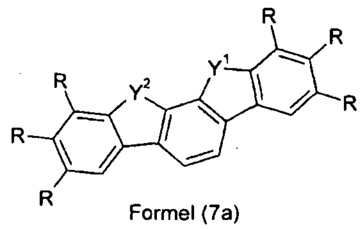
Formel (7a)

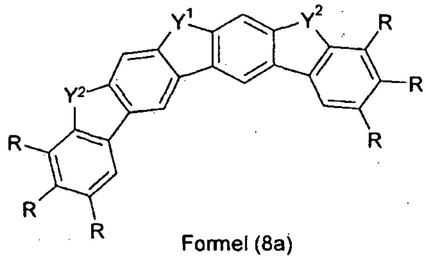
Formel (8a)

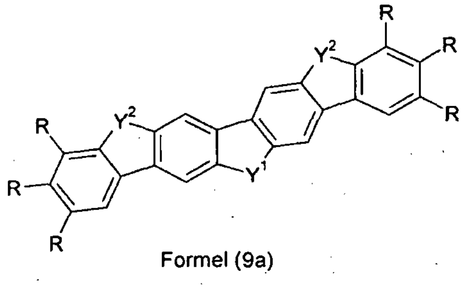
Formel (9a)

wobei die verwendeten Symbole die in Anspruch 1 genannten Bedeutungen aufweisen.

**10.** Organische Elektrolumineszenzvorrichtung nach einem oder mehreren der Ansprüche 1 bis 9, **dadurch gekennzeichnet, dass** $Y^1$ und $Y^2$ gleich oder verschieden bei jedem Auftreten ausgewählt sind aus der Gruppe bestehend aus $CR_2$, NR, O oder S, wobei bevorzugt mindestens eine der Gruppen $Y^1$ und $Y^2$ für ein Heteroatom steht.

**11.** Organische Elektrolumineszenzvorrichtung nach einem oder mehreren der Ansprüche 1 bis 10, **dadurch gekennzeichnet, dass** eine der Gruppen $Y^1$ bzw. $Y^2$ für $CR_2$ steht und die andere der Gruppen $Y^1$ bzw. $Y^2$ für NR steht oder dass beide Gruppen $Y^1$ und $Y^2$ für NR stehen oder dass beide Gruppen $Y^1$ und $Y^2$ für stehen.

**12.** Organische Elektrolumineszenzvorrichtung nach einem oder mehreren der Ansprüche 1 bis 11, **dadurch gekennzeichnet, dass** mindestens eine der Gruppen $Y^1$ oder $Y^2$ für NR steht und dieser Substituent R für ein aromatisches oder heteroaromatisches Ringsystem mit 5 bis 24 aromatischen Ringatomen, welches auch durch einen oder mehrere Reste $R^1$ substituiert sein kann, steht, insbesondere ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quäterphenyl; 1-, 2-, 3- oder 4-Fluorenyl, 1-, 2-, 3- oder 4-Spirobifluorenyl, 1- oder 2-Naphthyl, Pyrrol, Furan, Thiophen, Indol, Benzofuran, Benzöthiophen, 1-, 2- oder 3-Carbazol, 1-, 2- oder 3-Dibenzofuran, 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Phenanthren oder Kombinationen aus zwei oder drei dieser Gruppen, welche jeweils mit einem oder mehreren Resten $R^1$ substituiert sein können.

**13.** Organische Elektrolumineszenzvorrichtung nach einem oder mehreren der Ansprüche 1 bis 12, **dadurch gekennzeichnet, dass** mindestens eine der Gruppen $Y^1$ oder $Y^2$ für $CR_2$ steht und R gleich oder verschieden bei jedem Auftreten für eine lineare Alkylgruppe mit 1 bis 10 C-Atomen oder für eine verzweigte oder cyclische Alkylgruppe mit 3 bis 10 C-Atomen oder für ein aromatisches oder heteroaromatisches Ringsystem mit 5 bis 24 aromatischen Ringatomen, welches auch durch einen oder mehrere Reste $R^1$ substituiert sein kann, steht, wobei die R auch ein Ringsystem miteinander bilden können.

**14.** Verfahren zur Herstellung einer organischen Elektrolumineszenzvorrichtung nach einem oder mehreren der Ansprüche 1 bis 13, **dadurch gekennzeichnet, dass** mindestens eine Schicht mit einem Sublimationsverfahren aufgebracht wird und/oder dass mindestens eine Schicht mit einem OVPD Verfahren oder mit Hilfe einer Trägergassublimation aufgebracht wird und/oder dass mindestens eine Schicht aus Lösung, durch Spincoating oder mit einem Druckverfahren aufgebracht wird.

## Claims

1. Organic electroluminescent device comprising cathode, anode and emitting layer, which comprises the following compounds:

(A) a luminescent organic compound which is an aromatic compound which contains both donor and acceptor substituents, where the donor substituents are selected from the group consisting of diaryl- and heteroarylamino groups, carbazole groups and carbazole derivatives, which may in each case also be substituted, and where the acceptor substituents are selected from the group consisting of cyano groups and electron-deficient heteroaryl groups, which may also be substituted, and which has a separation between the lowest triplet state $T_1$ and the first excited singlet state $S_1$ of $\leq 0.15$ eV (TADF compound); and
(B) a compound of the formula (1),

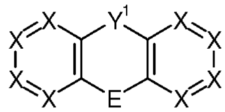

formula (1)

where the following applies to the symbols used:

X is on each occurrence, identically or differently, CR or N, or a group X-X stands for a group of the following formula (2), with the proviso that at least one group X-X stands for a group of the formula (2) and that a maximum of one group X-X per ring stands for a group of the formula (2),

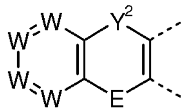

formula (2)

where the C atoms with the dashed bonds indicate the bonding of the group;
$Y^1$, $Y^2$ are selected on each occurrence, identically or differently, from the group consisting of $CR_2$, NR, O, S, $SiR_2$, BR, PR and P(=O)R;
E is selected on each occurrence, identically or differently, from the group consisting of a single bond, $CR_2$, NR, O, S, $SiR_2$, BR, PR and P(=O)R;
W is on each occurrence, identically or differently, CR or N;
R is selected on each occurrence, identically or differently, from the group consisting of H, D, F, Cl, Br, I, CN, $NO_2$, $N(Ar)_2$, $N(R^1)_2$, C(=O)Ar, $C(=O)R^1$, $P(=O)(Ar)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^1$, where one or more non-adjacent $CH_2$ groups may be replaced by $R^1C=CR^1$, C≡C, $Si(R^1)_2$, C=O, C=S, $C=NR^1$, $P(=O)(R^1)$, SO, $SO_2$, $NR^1$, O, S or $CONR^1$ and where one or more H atoms may be replaced by D, F, Cl, Br, I, CN or $NO_2$, an aromatic or heteroaromatic ring system having 5 to 80 aromatic ring atoms, which may in each case be substituted by one or more radicals $R^1$, an aryloxy or heteroaryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$, where two or more adjacent substituents R may optionally form a monocyclic or polycyclic, aliphatic, aromatic or heteroaromatic ring system, which may be substituted by one or more radicals $R^1$;
$R^1$ is selected on each occurrence, identically or differently, from the group consisting of H, D, F, Cl, Br, I, CN, $NO_2$, $N(Ar)_2$, $N(R^2)_2$, C(=O)Ar, $C(=O)R^2$, $P(=O)(Ar)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^2$, where one or more non-adjacent $CH_2$ groups may be replaced by $R^2C=CR^2$, C≡C, $Si(R^2)_2$, C=O, C=S, $C=NR^2$, $P(=O)(R^2)$, SO, $SO_2$, $NR^2$, O, S or $CONR^2$ and where one or more H atoms may be replaced by D, F, Cl, Br, I, CN or $NO_2$, an aromatic or heteroaromatic ring system having 5 to 60 aromatic ring atoms, which may in each

case be substituted by one or more radicals $R^2$, an aryloxy or heteroaryloxy group having 5 to 60 aromatic ring atoms, which may be substituted by one or more radicals $R^2$, or an aralkyl or heteroaralkyl group having 5 to 60 aromatic ring atoms, where two or more adjacent substituents $R^1$ may optionally form a monocyclic or polycyclic, aliphatic, aromatic or heteroaromatic ring system, which may be substituted by one or more radicals $R^2$;

Ar is on each occurrence, identically or differently, an aromatic or heteroaromatic ring system having 5-30 aromatic ring atoms, which may be substituted by one or more non-aromatic radicals $R^2$; two radicals Ar which are bonded to the same N atom or P atom may also be bridged to one another by a single bond or a bridge selected from $N(R^2)$, $C(R^2)_2$, O or S;

$R^2$ is selected from the group consisting of H, D, F, CN, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I or CN, where two or more adjacent substituents $R^2$ may form a mono- or polycyclic, aliphatic, aromatic or heteroaromatic ring system with one another.

2. Organic electroluminescent device according to Claim 1, **characterised in that** the TADF compound in a layer in a mixture with the compound of the formula (1) has a luminescence quantum efficiency of at least 40%.

3. Organic electroluminescent device according to Claim 1 or 2, **characterised in that** the separation between $S_1$ and $T_1$ of the TADF compound is $\leq 0.10$ eV, preferably $\leq 0.08$ eV and particularly preferably $\leq 0.05$ eV.

4. Organic electroluminescent device according to one or more of Claims 1 to 3, **characterised in that** the following applies to the LUMO of the TADF compound LUMO(TADF) and the HOMO of the compound of the formula (1) HOMO(matrix):

$$\text{LUMO(TADF)} - \text{HOMO(matrix)} > S_1\text{(TADF)} - 0.4\ \text{eV},$$

where $S_1$(TADF) is the first excited singlet state $S_1$ of the TADF compound.

5. Organic electroluminescent device according to one or more of Claims 1 to 4, **characterised in that** the lowest triplet energy of the compound of the formula (1) is a maximum of 0.1 eV lower than the triplet energy of the TADF compound.

6. Organic electroluminescent device according to one or more of Claims 1 to 5, **characterised in that** E is selected on each occurrence, identically or differently, from the group consisting of a single bond, $CR_2$, NR, O or S.

7. Organic electroluminescent device according to one or more of Claims 1 to 6, **characterised in that** the compound of the formula (1) is selected from the compounds of the formulae (3) to (9),

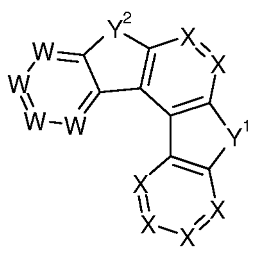
formula (3)

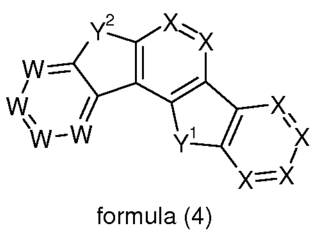
formula (4)

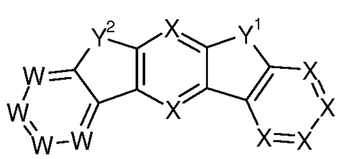
formula (5)

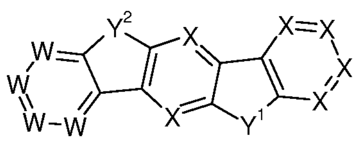

formula (6)

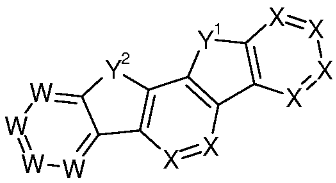

formula (7)

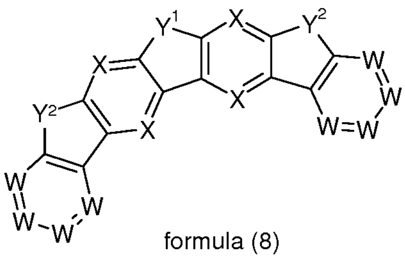

formula (8)

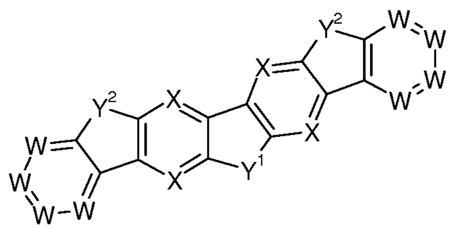

formula (9)

where W, $Y^1$, $Y^2$, R, $R^1$ and $R^2$ have the meanings given in Claim 1 and furthermore:

X is on each occurrence, identically or differently, CR or N.

**8.** Organic electroluminescent device according to one or more of Claims 1 to 7, **characterised in that** a maximum of one symbol X per ring stands for N and **in that** a maximum of one symbol W per ring stands for N.

**9.** Organic electroluminescent device according to one or more of Claims 1 to 8, **characterised in that** the compound of the formula (1) is selected from the compounds of the formulae (3a) to (9a),

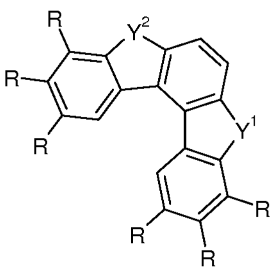

formula (3a)

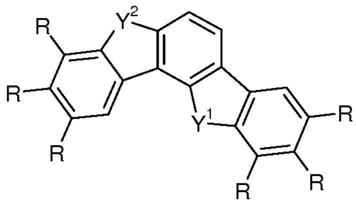

formula (4a)

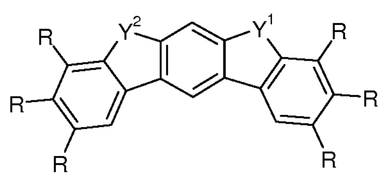

formula (5a)

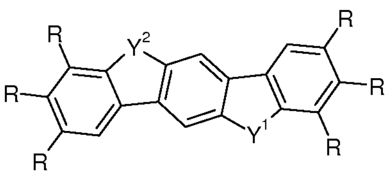

formula (6a)

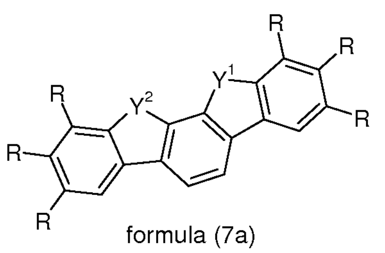

formula (7a)

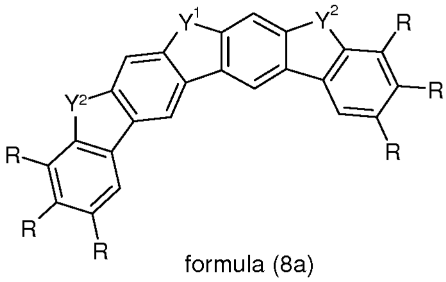

formula (8a)

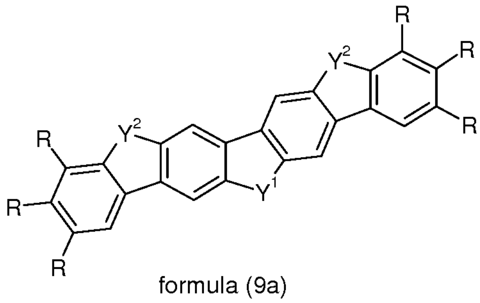

formula (9a)

where the symbols used have the meanings given in Claim 1.

**10.** Organic electroluminescent device according to one or more of Claims 1 to 9, **characterised in that** $Y^1$ and $Y^2$ are selected, identically or differently on each occurrence, from the group consisting of $CR_2$, NR, O or S, where preferably at least one of the groups $Y^1$ and $Y^2$ stands for a heteroatom.

**11.** Organic electroluminescent device according to one or more of Claims 1 to 10, **characterised in that** one of the groups $Y^1$ and $Y^2$ stands for $CR_2$ and the other of the groups $Y^1$ and $Y^2$ stands for NR or **in that** both groups $Y^1$ and $Y^2$ stand for NR or **in that** both groups $Y^1$ and $Y^2$ stand for O.

**12.** Organic electroluminescent device according to one or more of Claims 1 to 11, **characterised in that** at least one of the groups $Y^1$ and $Y^2$ stands for NR and this substituent R stands for an aromatic or heteroaromatic ring system having 5 to 24 aromatic ring atoms, which may also be substituted by one or more radicals $R^1$, in particular selected from the group consisting of benzene, ortho-, meta- or para-biphenyl, ortho-, meta-, para- or branched terphenyl, ortho-, meta-, para- or branched quaterphenyl, 1-, 2-, 3- or 4-fluorenyl, 1-, 2-, 3- or 4-spiro-bifluorenyl, 1- or 2-naphthyl, pyrrole, furan, thiophene, indole, benzofuran, benzothiophene, 1-, 2- or 3-carbazole, 1-, 2- or 3-dibenzofuran, 1-, 2- or 3-dibenzothiophene, indenocarbazole, indolocarbazole, 2-, 3- or 4-pyridine, 2-, 4- or 5-pyrimidine, pyrazine, pyridazine, triazine, phenanthrene or combinations of two or three of these groups, which may in each case be substituted by one or more radicals $R^1$.

**13.** Organic electroluminescent device according to one or more of Claims 1 to 12, **characterised in that** at least one of the groups $Y^1$ and $Y^2$ stands for $CR_2$ and R stands, identically or differently on each occurrence, for a linear alkyl group having 1 to 10 C atoms or for a branched or cyclic alkyl group having 3 to 10 C atoms or for an aromatic or heteroaromatic ring system having 5 to 24 aromatic ring atoms, which may also be substituted by one or more radicals $R^1$, where the R may also form a ring system with one another.

**14.** Process for the production of an organic electroluminescent device according to one or more of Claims 1 to 13, **characterised in that** at least one layer is applied by means of a sublimation process and/or **in that** at least one layer is applied by means of an OVDP process or with the aid of carrier-gas sublimation and/or **in that** at least one layer is applied from solution, by spin coating or by means of a printing process.

## Revendications

**1.** Dispositif électroluminescent organique comprenant une cathode, une anode et une couche d'émission, laquelle comprend les composés qui suivent :

(A) un composé organique luminescent qui est un composé aromatique qui contient à la fois des substituants donneurs et accepteurs, où les substituants donneurs sont sélectionnés parmi le groupe qui est constitué par les groupes diarylamino et hétéroarylamino, les groupes carbazole et les dérivés de carbazole, lesquels peuvent dans chaque cas également être substitués, et où les substituants accepteurs sont sélectionnés parmi le groupe qui est constitué par les groupes cyano et les groupes hétéroaryle déficients en électrons, lesquels peuvent également être substitués, et lequel présente une séparation entre l'état triplet le plus bas $T_1$ et le premier état singulet excité $S_1$ qui est $\leq$ 0,15 eV (composé TADF) ; et
(B) un composé de la formule (1) :

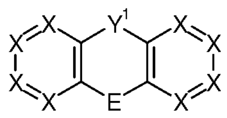

formule (1)

dans laquelle ce qui suit s'applique aux symboles qui sont utilisés :

X est pour chaque occurrence, de manière identique ou différente, CR ou N, ou un groupe X-X représente un groupe de la formule (2) qui suit, étant entendu qu'au moins un groupe X-X représente un groupe de la formule (2) et qu'un maximum d'un groupe X-X par cycle représente un groupe de la formule (2) :

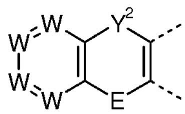

formule (2)

dans laquelle les atomes de C avec les liaisons en pointillés indiquent la liaison du groupe ;
$Y^1$, $Y^2$ sont sélectionnés pour chaque occurrence, de manière identique ou différente, parmi le groupe qui est constitué par $CR_2$, NR, O, S, $SiR_2$, BR, PR et P(=O)R ;
E est sélectionné pour chaque occurrence, de manière identique ou différente, parmi le groupe qui est constitué par une liaison simple, $CR_2$, NR, O, S, $SiR_2$, BR, PR et P(=O)R ;
W est pour chaque occurrence, de manière identique ou différente, CR ou N ;
R est sélectionné pour chaque occurrence, de manière identique ou différente, parmi le groupe qui est constitué par H, D, F, Cl, Br, I, CN, $NO_2$, $N(Ar)_2$, $N(R^1)_2$, C(=O)Ar, $C(=O)R^1$, $P(=O)(Ar)_2$, un groupe alkyle, alcoxy ou thioalkyle en chaîne droite qui comporte de 1 à 40 atome(s) de C ou un groupe alkyle, alcoxy ou thioalkyle ramifié ou cyclique qui comporte de 3 à 40 atomes de C ou un groupe alkényle ou alkynyle qui comporte de 2 à 40 atomes de C, lequel peut dans chaque cas être substitué par un radical ou par plusieurs radicaux $R^1$, où un ou plusieurs groupe(s) $CH_2$ non adjacents peut/peuvent être remplacé(s) par $R^1C=CR^1$ C≡C, $Si(R^1)_2$, C=O, C=S, $C=NR^1$, $P(=O)(R^1)$, SO, $SO_2$, $NR^1$, O, S ou $CONR^1$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 80 atomes de cycle aromatique, lequel peut dans chaque cas être substitué par un radical ou par plusieurs radicaux $R^1$, un groupe aryloxy ou hétéroaryloxy qui comporte de 5 à 60 atomes de cycle aromatique, lequel peut être substitué par un radical ou par plusieurs radicaux $R^1$, ou un groupe aralkyle ou hétéroaralkyle qui comporte de 5 à 60 atomes de cycle aromatique, lequel peut être substitué par un radical ou par plusieurs radicaux $R^1$, où deux substituants R adjacents ou plus peuvent en option former un système de cycle aliphatique, aromatique ou hétéroaromatique monocyclique ou polycyclique, lequel peut être substitué par un radical ou par plusieurs radicaux $R^1$ ;
$R^1$ est sélectionné pour chaque occurrence, de manière identique ou différente, parmi le groupe qui est constitué par H, D, F, Cl, Br, I, CN, $NO_2$, $N(Ar)_2$, $N(R^2)_2$, C(=O)Ar, $C(=O)R^2$, $P(=O)(Ar)_2$, un groupe alkyle, alcoxy ou thioalkyle en chaîne droite qui comporte de 1 à 40 atome(s) de C ou un groupe alkyle, alcoxy ou thioalkyle ramifié ou cyclique qui comporte de 3 à 40 atomes de C ou un groupe alkényle ou alkynyle qui comporte de 2 à 40 atomes de C, lequel peut dans chaque cas être substitué par un radical ou par plusieurs radicaux $R^2$, où un ou plusieurs groupe(s) $CH_2$ non adjacents peut/peuvent être remplacé(s) par $R^2C=CR^2$, C≡C, $Si(R^2)_2$, C=O, C=S, $C=NR^2$, $P(=O)(R^2)$, SO, $SO_2$, $NR^2$, O, S ou $CONR^2$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 60 atomes de cycle aromatique, lequel peut dans chaque cas être substitué par un radical ou par plusieurs radicaux $R^2$, un groupe aryloxy ou hétéroaryloxy qui comporte de 5 à 60 atomes de cycle aromatique, lequel peut être substitué par un radical ou par plusieurs radicaux $R^2$, ou un groupe aralkyle ou hétéroaralkyle qui comporte de 5 à 60 atomes de cycle aromatique, où deux substituants $R^1$ adjacents ou plus peuvent en option former un système de cycle aliphatique, aromatique ou hétéroaromatique monocyclique ou polycyclique, lequel peut être substitué par un radical ou par plusieurs radicaux $R^2$ ;
Ar est pour chaque occurrence, de manière identique ou différente, un système de cycle aromatique ou hétéroaromatique qui comporte de 5 à 30 atomes de cycle aromatique, lequel peut être substitué par un radical ou par plusieurs radicaux $R^2$ non aromatique(s) ; deux radicaux Ar qui sont liés au même atome de N ou au même

atome de P peuvent également être pontés l'un à l'autre au moyen d'une liaison simple ou au moyen d'un pont qui est sélectionné parmi $N(R^2)$, $C(R^2)_2$, O ou S ;
$R^2$ est sélectionné parmi le groupe qui est constitué par H, D, F, CN, un radical hydrocarbone aliphatique qui comporte de 1 à 20 atome(s) de C, un système de cycle aromatique ou hétéroaromatique qui comporte de 5 à 30 atomes de cycle aromatique, dans lequel un ou plusieurs atome(s) de H peut/peuvent être remplacé(s) par D, F, Cl, Br, I ou CN, où deux substituants $R^2$ adjacents ou plus peuvent former un système de cycle aliphatique, aromatique ou hétéroaromatique monocyclique ou polycyclique l'un avec l'autre ou les uns avec les autres.

2. Dispositif électroluminescent organique selon la revendication 1, **caractérisé en ce que** le composé TADF dans une couche selon un mélange/une mixture avec le composé de la formule (1) présente un rendement quantique de luminescence d'au moins 40%.

3. Dispositif électroluminescent organique selon la revendication 1 ou 2, **caractérisé en ce que** la séparation entre $S_1$ et $T_1$ du composé TADF est $\leq$ 0,10 eV, de préférence $\leq$ 0,08 eV et de façon particulièrement préférable $\leq$ 0,05 eV.

4. Dispositif électroluminescent organique selon une ou plusieurs des revendications 1 à 3, **caractérisé en ce que** ce qui suit s'applique au niveau d'énergie LUMO du composé TADF LUMO(TADF) et au niveau d'énergie HOMO du composé de la formule (1) HOMO(matrice) :

$$\text{LUMO(TADF)} - \text{HOMO(matrice)} > S_1\text{(TADF)} - 0{,}4\ \text{eV},$$

où $S_1$(TADF) est le premier état singulet excité $S_1$ du composé TADF.

5. Dispositif électroluminescent organique selon une ou plusieurs des revendications 1 à 4, **caractérisé en ce que** le niveau d'énergie de triplet le plus bas du composé de la formule (1) est un maximum de 0,1 eV plus faible que le niveau d'énergie de triplet du composé TADF.

6. Dispositif électroluminescent organique selon une ou plusieurs des revendications 1 à 5, **caractérisé en ce que** E est sélectionné pour chaque occurrence, de manière identique ou différente, parmi le groupe qui est constitué par une liaison simple, $CR_2$, NR, O ou S.

7. Dispositif électroluminescent organique selon une ou plusieurs des revendications 1 à 6, **caractérisé en ce que** le composé de la formule (1) est sélectionné parmi les composés des formules (3) à (9) :

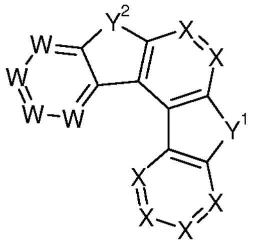

formule (3)

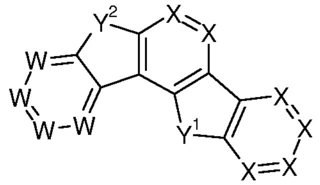

formule (4)

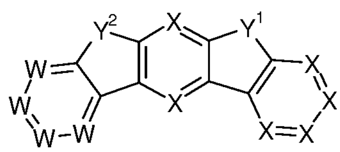

formule (5)

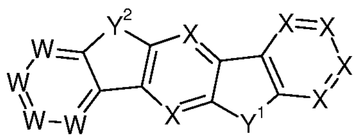

formule (6)

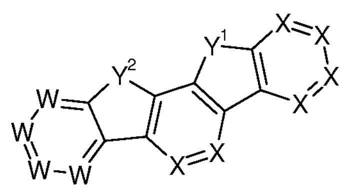

formule (7)

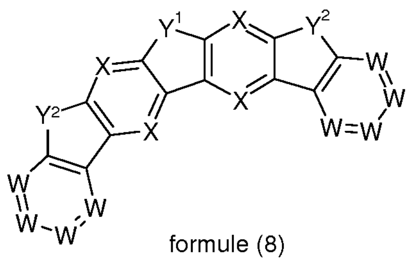

formule (8)

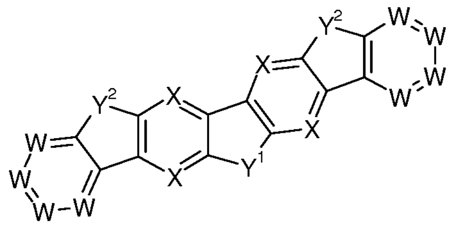

formule (9)

dans lesquelles W, $Y^1$, $Y^2$, R, $R^1$ et $R^2$ présentent les significations qui ont été données selon la revendication 1 et en outre :

X est pour chaque occurrence, de manière identique ou différente, CR ou N.

**8.** Dispositif électroluminescent organique selon une ou plusieurs des revendications 1 à 7, **caractérisé en ce qu'**un maximum d'un symbole X par cycle représente N et **en ce qu'**un maximum d'un symbole W par cycle représente N.

**9.** Dispositif électroluminescent organique selon une ou plusieurs des revendications 1 à 8, **caractérisé en ce que** le composé de la formule (1) est sélectionné parmi les composés des formules (3a) à (9a) :

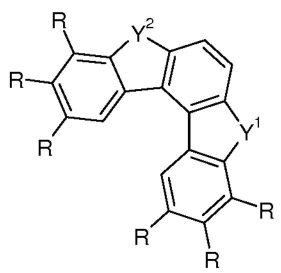

formule (3a)

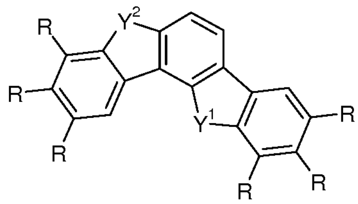

formule (4a)

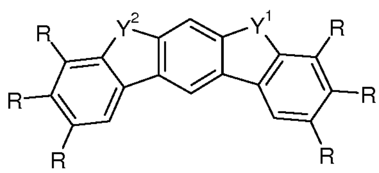

formule (5a)

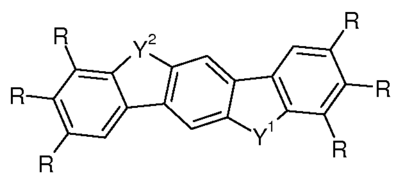

formule (6a)

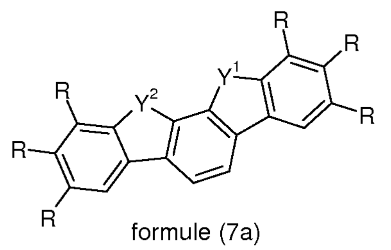

formule (7a)

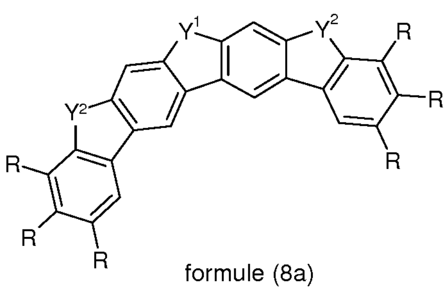

formule (8a)

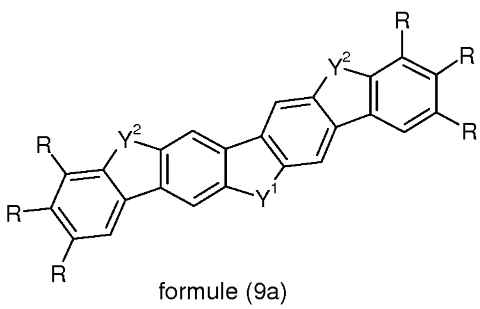

formule (9a)

dans lesquelles les symboles qui sont utilisés présentent les significations qui ont été données selon la revendication 1.

**10.** Dispositif électroluminescent organique selon une ou plusieurs des revendications 1 à 9, **caractérisé en ce que** les groupes $Y^1$ et $Y^2$ sont sélectionnés, de manière identique ou différente pour chaque occurrence, parmi le groupe qui est constitué par $CR_2$, NR, O ou S, où, de préférence, au moins l'un des groupes $Y^1$ et $Y^2$ représente un hétéroatome.

**11.** Dispositif électroluminescent organique selon une ou plusieurs des revendications 1 à 10, **caractérisé en ce que** l'un des groupes $Y^1$ et $Y^2$ représente $CR_2$ et l'autre des groupes $Y^1$ et $Y^2$ représente NR ou **en ce que** les deux groupes $Y^1$ et $Y^2$ représentent NR ou **en ce que** les deux groupes $Y^1$ et $Y^2$ représentent O.

**12.** Dispositif électroluminescent organique selon une ou plusieurs des revendications 1 à 11, **caractérisé en ce qu'**au moins l'un des groupes $Y^1$ et $Y^2$ représente NR et ce substituant R représente un système de cycle aromatique ou hétéroaromatique qui comporte de 5 à 24 atomes de cycle aromatique, lequel peut également être substitué par un radical ou par plusieurs radicaux $R^1$, en particulier pris par sélection parmi le groupe qui est constitué par les groupes benzène, ortho-, méta- ou para-biphényle, ortho-, méta- ou para-terphényle ou terphényle ramifié, ortho-, méta- ou para-quaterphényle ou quaterphényle ramifié, 1-, 2-, 3- ou 4-fluorényle, 1-, 2-, 3- ou 4-spirobifluorényle, 1- ou 2-naphtyle, pyrrole, furane, thiophène, indole, benzofurane, benzothiophène, 1-, 2- ou 3-carbazole, 1-, 2- ou 3-dibenzofurane, 1-, 2- ou 3-dibenzothiophène, indénocarbazole, indolocarbazole, 2-, 3- ou 4-pyridine, 2-, 4- ou 5-pyrimidine, pyrazine, pyridazine, triazine, phénanthrène ou des combinaisons de deux ou trois de ces groupes, lequel/lesquels peut/peuvent dans chaque cas être substitué(s) par un radical ou par plusieurs radicaux $R^1$.

**13.** Dispositif électroluminescent organique selon une ou plusieurs des revendications 1 à 12, **caractérisé en ce qu'**au moins l'un des groupes $Y^1$ et $Y^2$ représente $CR_2$ et R représente, de manière identique ou différente pour chaque occurrence, un groupe alkyle linéaire qui comporte de 1 à 10 atome(s) de C ou un groupe alkyle ramifié ou cyclique qui comporte de 3 à 10 atomes de C ou un système de cycle aromatique ou hétéroaromatique qui comporte de 5 à 24 atomes de cycle aromatique, lequel peut également être substitué par un radical ou par plusieurs radicaux $R^1$, où les R peuvent également former un système de cycle l'un avec l'autre ou les uns avec les autres.

**14.** Procédé pour la production d'un dispositif électroluminescent organique selon une ou plusieurs des revendications 1 à 13, **caractérisé en ce qu'**au moins une couche est appliquée au moyen d'un procédé de sublimation et/ou **en ce qu'**au moins une couche est appliquée au moyen d'un procédé de dépôt en phase vapeur organique/OVDP ou à l'aide d'une sublimation par gaz porteur et/ou **en ce qu'**au moins une couche est appliquée à partir d'une solution, au moyen d'un revêtement à la tournette/par centrifugation ou au moyen d'un procédé d'impression.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- EP 1956022 A1
- WO 2011073149 A
- EP 1968131 A
- EP 2276085 A
- EP 2213662 A
- EP 1722602 A
- EP 2045848 A
- DE 102007031220
- US 8044390 B
- US 8057712 B
- WO 2009003455 A
- WO 2010094378 A
- WO 2011120709 A
- US 20100096600 A


### In der Beschreibung aufgeführte Nicht-Patentliteratur


- **M. A. BALDO et al.** *Appl. Phys. Lett.,* 1999, vol. 75, 4-6
- **B. H. UOYAMA et al.** *Nature,* 2012, vol. 492, 234
- **H. UOYAMA et al.** *Nature,* 2012, vol. 492, 234
- **ENDO et al.** *Appl. Phys. Lett.,* 2011, vol. 98, 083302
- **NAKAGAWA et al.** *Chem. Commun.,* 2012, vol. 48, 9580
- **LEE et al.** *Appl. Phys. Lett.,* 2012, vol. 101, 093306, , 1
- **MEHES et al.** *Angew. Chem. Int. Ed.,* 2012, vol. 51, 11311
- *Chem. Rev.,* 2007, vol. 107, 1233
- **M. S. ARNOLD et al.** *Appl. Phys. Lett.,* 2008, vol. 92, 053301
- **B. H. UOYAMA et al.** *Nature,* 2012, vol. 492 (7428), 234-238
- **K. MASUI et al.** *Organic Electronics,* 2013, vol. 14 (11), 2721-2726